# EUROPEAN PATENT APPLICATION

(11) **EP 4 746 615 A1**
(43) Date of publication of application: **20.05.2026**
(21) Application number: 25212886.3
(22) Date of filing: 03.11.2025
(51) Int. Cl.: H10B 12/00, H10D 30/67, G11C 11/403

(54) **SEMICONDUCTOR DEVICE AND METHOD FOR FABRICATING THE SAME**

(30) Priority: 19.11.2024 KR 20240165691
(71) Applicant: SK hynix Inc., Bubal-eub Icheon-si Gyeonggi-do 17336 (KR)
(72) Inventor: KIM, Wha Young, 17336 Incheon-si, Gyeonggi-do (KR); PARK, Gyeong Cheol, 17336 Icheon-si, Gyeonggi-do (KR); WOO, Jung Wook, 17336 Icheon-si, Gyeonggi-do (KR); LEE, Byoung Seok, 17336 Icheon-si, Gyeonggi-do (KR); CHA, Jun Hwe, 17336 Icheon-si, Gyeonggi-do (KR)
(74) Representative: Isarpatent

(57) **Abstract**

The semiconductor device includes a first channel structure; a first air layer surrounding a side surface of the first channel structure; a first bitline contacting the side surface of the first channel structure; a first wordline contacting a lower portion of the first channel structure; a storage node having one end contacting an upper portion of the first channel structure; a second channel structure contacting an upper portion of the storage node; a second air layer surrounding a side surface of the second channel structure; a second bitline contacting the side surface of the second channel structure; and a second wordline contacting an upper portion of the second channel structure. The first bitline extends in a direction perpendicular to a direction in which the first channel structure extends. The second wordline extends in a direction perpendicular to a direction in which the second channel structure extends.

## Description

### TECHNICAL FIELD

The technology and implementations disclosed in this patent document generally relate to a semiconductor device, and more particularly to a semiconductor device including memory cells.

### BACKGROUND

As miniaturization and higher degree of integration of semiconductor devices have become major issues, memory cells included in semiconductor devices can be formed to have three-dimensional (3D) patterns. Miniaturized memory cells with three-dimensional (3D) patterns can be equipped with configurations that improve operation characteristics of the memory cells.

### SUMMARY

Various embodiments of the present disclosure relate to a semiconductor memory device that includes two transistors and has a higher degree of integration.

Various embodiments of the present disclosure relate to a semiconductor memory device configured to be less affected by parasitic capacitance.

In accordance with an embodiment of the present disclosure, a semiconductor device may include a first channel structure; a first air layer configured to surround a side surface of the first channel structure; a first bitline disposed to contact the side surface of the first channel structure; a first wordline disposed to contact a lower portion of the first channel structure; a storage node having one end contacting an upper portion of the first channel structure; a second channel structure disposed to contact an upper portion of the storage node; a second air layer configured to surround a side surface of the second channel structure; a second bitline disposed to contact the side surface of the second channel structure; and a second wordline disposed to contact an upper portion of the second channel structure. The first bitline extends in a direction perpendicular to a direction in which the first channel structure extends, and the second wordline extends in a direction perpendicular to a direction in which the second channel structure extends.

In some other implementations, the direction in which the first bitline extends is perpendicular to the direction in which the second wordline extends.

In some other implementations, the first air layer may include a first vertical extension portion disposed between two adjacent first bitlines.

In some other implementations, the second air layer may include a second vertical extension portion disposed between two adjacent second bitlines.

In some other implementations, the first channel structure may include: a first gate having a pillar shape extending in a vertical direction; a first gate insulation layer configured to surround a side surface and a bottom surface of the first gate; and a first channel region configured to surround the first gate insulation layer. The second channel structure may include: a second gate having a pillar shape extending in the vertical direction; a second gate insulation layer configured to surround a side surface and a bottom surface of the second gate; and a second channel region configured to surround the second gate insulation layer.

In some other implementations, the semiconductor device may further include a peripheral region disposed below the first wordline.

In some other implementations, the first air layer may include a first gapfill region disposed in the first vertical extension portion.

In some other implementations, the second air layer may include a second gapfill region disposed in the second vertical extension portion.

In some other implementations, the first air layer may include a first residual sacrificial layer disposed to contact a sidewall of the first channel structure.

In some other implementations, the second air layer may include a second residual sacrificial layer disposed to contact a sidewall of the second channel structure.

In some other implementations, the first air layer may be disposed between the first bitline and the first wordline and configured to surround a portion of a sidewall of the first channel structure.

In some other implementations, the second air layer may be disposed between the second bitline and the second wordline and configured to surround a portion of a sidewall of the second channel structure.

In accordance with another embodiment of the present disclosure, a semiconductor device may include: a plurality of first wordlines each disposed to extend in a first direction; a plurality of first channel structures respectively disposed to contact upper portions of the plurality of first wordlines and to extend in a second direction perpendicular to the first direction; a plurality of first bitlines having a common contact to side surfaces of first channel structures arranged parallel to each other in a third direction, among the plurality of first channel structures; a first air layer disposed between the plurality of first channel structures; a plurality of storage nodes respectively disposed to contact upper portions of the plurality of first channel structures; a plurality of second channel structures respectively disposed to contact the plurality of storage nodes and to extend in the second direction; a plurality of second bitlines having a common contact to side surfaces of second channel structures arranged parallel to each other in the third direction, among the plurality of second channel structures; a second air layer disposed between the plurality of second channel structures; and a plurality of second wordlines respectively disposed to contact upper portions of second channel structures arranged parallel to each other in the first direction, among the plurality of second channel structures.

In some other implementations, the first air layer may surround a portion of the side surfaces of the plurality of first channel structures; and the second air layer may surround a portion of the side surfaces of the plurality of second channel structures.

In some other implementations, the plurality of first wordlines may be repeatedly arranged in the third direction; and the plurality of second wordlines may be repeatedly arranged in the third direction.

In some other implementations, each of the plurality of first channel structures may include: a first gate having a pillar shape extending in a vertical direction; a first gate insulation layer configured to surround a side surface and a bottom surface of the first gate; and a first channel region configured to surround the first gate insulation layer. Each of the plurality of second channel structures may include: a second gate having a pillar shape extending in the vertical direction; a second gate insulation layer configured to surround a side surface and a bottom surface of the second gate; and a second channel region configured to surround the second gate insulation layer.

In some other implementations, at least a portion of the first air layer may be disposed below the plurality of first bitlines; and at least a portion of the second air layer may be disposed below the plurality of second bitlines.

In some other implementations, the first air layer may include a plurality of first vertical extension portions each disposed between two adjacent first bitlines among the plurality of first bitlines and to extend in the third direction, and the second air layer includes a plurality of second vertical extension portions each disposed between two adjacent second bitlines among the plurality of second bitlines and to extend in the third direction.

In accordance with another embodiment of the present disclosure, a method for manufacturing a semiconductor device may include: forming a first wordline on a substrate; forming a first bitline over the first wordline; forming a first channel structure so that a bottom surface of the first channel structure contacts the first wordline and a side surface of the first channel structure contacts the first bitline; forming a first air layer to surround a side surface of the first channel structure; forming a storage node to contact a top surface of the first channel structure; forming a second bitline over the storage node; forming a second channel structure so that a bottom surface of the second channel structure contacts the storage node and a side surface of the second channel structure contacts the second bitline; and forming a second air layer to surround a side surface of the second channel structure.

It is to be understood that both the foregoing general description and the following detailed description of the present disclosure are illustrative and explanatory and are intended to provide further explanation of the disclosure as claimed.

### BRIEF DESCRIPTION OF THE DRAWINGS

The above and other features and beneficial aspects of the present disclosure will become readily apparent with reference to the following detailed description when considered in conjunction with the accompanying drawings.
FIG. 1 is a schematic perspective view illustrating an example of a portion of a memory cell array of a semiconductor device based on some embodiments of the present disclosure.
FIG. 2 is a circuit diagram illustrating an example of an equivalent circuit of a memory cell based on some embodiments of the present disclosure.
FIG. 3A is a plan view illustrating a portion of a memory cell array when viewed from a second direction based on some embodiments of the present disclosure.
FIG. 3B is a cross-sectional view illustrating an example of a memory cell taken along a first cutting line of FIG. 3A based on some embodiments of the present disclosure.
FIG. 3C is a cross-sectional view illustrating an example of a memory cell taken along a second cutting line of FIG. 3A based on some embodiments of the present disclosure.
FIG. 4A is a plan view illustrating a portion of a memory cell array when viewed from a second direction based on some other embodiments of the present disclosure.
FIG. 4B is a cross-sectional view illustrating an example of a memory cell taken along a third cutting line of FIG. 4A based on some other embodiments of the present disclosure.
FIG. 4C is a cross-sectional view illustrating an example of a memory cell taken along a fourth cutting line of FIG. 4A based on some other embodiments of the present disclosure.
FIGS. 5A to 26C are diagrams illustrating examples of a method for manufacturing the semiconductor device based on some embodiments of the present disclosure.

### DETAILED DESCRIPTION

The embodiments of the present disclosure provide implementations and examples of a semiconductor device including memory cells that may be used in configurations to substantially address one or more technical or engineering issues and to mitigate limitations or disadvantages encountered in some other semiconductor devices. Some implementations of the present disclosure relate to a semiconductor memory device that includes two transistors and has a higher degree of integration. Some implementations of the present disclosure relate to a semiconductor memory configured to be less affected by parasitic capacitance. In recognition of the issues above, the present disclosure may provide the semiconductor device that has three-dimensional (3D) channels to improve the degree of integration. The present disclosure may provide the semiconductor device having at least one transistor that operates as a storage element, resulting in a simplified fabrication process. The present disclosure may provide the semiconductor device including an air layer, resulting in reduction of signal distortion caused by parasitic capacitance.

Reference will now be made in detail to the embodiments of the present disclosure, examples of which are illustrated in the accompanying drawings. Wherever possible, the same reference numbers will be used throughout the drawings to refer to the same or like parts. While the disclosure is susceptible to various modifications and alternative forms, specific embodiments thereof are shown by way of example in the drawings. However, the disclosure should not be construed as being limited to the embodiments set forth herein.

Hereinafter, various embodiments will be described with reference to the accompanying drawings. However, it should be understood that the present disclosure is not limited to specific embodiments, but includes various modifications, equivalents and/or alternatives of the embodiments. The embodiments of the present disclosure may provide a variety of effects capable of being directly or indirectly recognized through the present disclosure.

In the following description, a detailed description of related known configurations or functions incorporated herein will be omitted to avoid obscuring the subject matter.

The terminology used herein is for the purpose of describing particular embodiments only and is not intended to be limiting of the present disclosure. As used herein, the singular forms are intended to include the plural forms as well, unless the context clearly indicates otherwise. It will be further understood that the terms "comprises", "includes", "including", and/or "comprising," when used in this specification, specify the presence of stated constituent elements, steps, operations, and/or components, but do not preclude the presence or addition of one or more other constituent elements, steps, operations, and/or components thereof. The term "and/or" may include a combination of a plurality of items or any one of a plurality of items.

Hereinafter, a semiconductor device and a method for manufacturing the same according to embodiments of the present disclosure will be described with reference to the attached drawings.

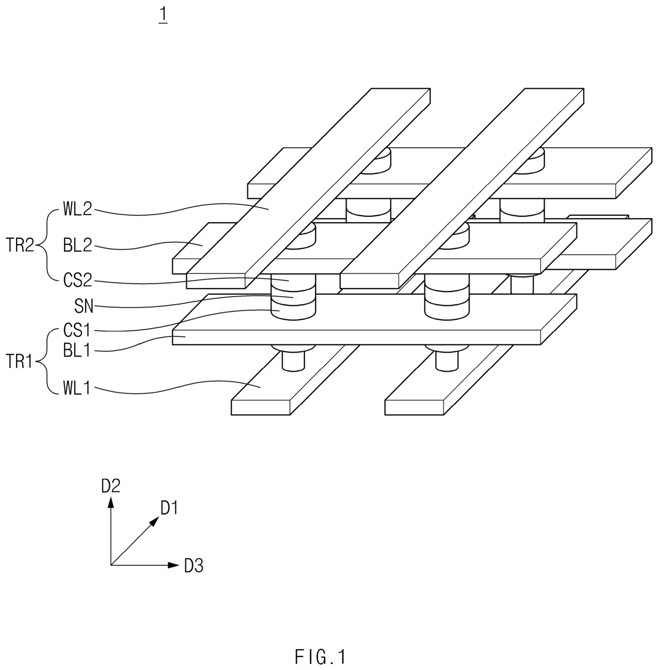

FIG. 1 is a schematic perspective view illustrating an example of a portion 1 of a memory cell array of a semiconductor device based on some embodiments of the present disclosure.

Referring to FIG. 1, the memory cell array may include a memory cell (MC), and each memory cell (MC) may include a first transistor (TR1), a storage node (SN), and a second transistor (TR2).

The first transistor (TR1) and the second transistor (TR2) may be arranged in a vertical direction, and the first transistor (TR1) and the second transistor (TR2) may be connected to the storage node (SN).

The first transistor (TR1) may include a first channel structure (CS1), a first bitline (BL1), and a first wordline (WL1).

The first wordline (WL1) may extend in a first direction (D1). A plurality of first channel structures (CS1) repeatedly arranged in the first direction (D1) may be disposed on the first wordline (WL1).

The plurality of first channel structures (CS1) repeatedly arranged in the first direction (D1) may be connected to one first wordline (WL1).

The first channel structure (CS1) may extend in a second direction (D2), and may include a plurality of layers. For example, the first channel structure (CS1) may include a first gate, a first gate insulation layer, and a first channel region.

The first channel structure (CS1) may be connected to the first wordline (WL1) through the first channel region.

A first bitline (BL1) may extend in a third direction (D3). The first bitline (BL1) may contact a side surface of the first channel region included in the first channel structure (CS1).

The first bitline (BL1) extending in the third direction (D3) may commonly contact (for example, contact each of, form a common contact to) the side surfaces of the plurality of first channel structures (CS1) repeatedly arranged in the third direction (D3). Particularly, the first bitline (BL1) may extend in a direction (D3) perpendicular to a direction (D2) in which the first channel structure (CS1) extends.

The storage node (SN) may be a region that is connected to the first channel structure (CS1) and the second channel structure (CS2). The storage node (SN) may contact a lower portion of a second channel region included in the second channel structure (CS2), and may contact an upper portion of a first gate included in the first channel structure (CS1).

The second channel structure (CS2) may be connected to an upper portion of the storage node (SN).

The second channel structure (CS2) may extend in the second direction (D2), and may include a plurality of layers. For example, the second channel structure (CS2) may include a second gate, a second gate insulation layer, and a second channel region.

A second bitline (BL2) may be connected to a side surface of the second channel structure (CS2).

The second bitline (BL2) may extend in the third direction (D3). The second bitline (BL2) may be connected to a side surface of a second channel region included in the second channel structure (CS2).

The second bitline (BL2) extending in the third direction (D3) may be connected to a side surface of the plurality of second channel structures (CS2) repeatedly arranged in the third direction (D3).

The second wordline (WL2) may be connected to an upper portion of the second channel structure (CS2). The second wordline (WL2) may be connected to an upper portion of the second gate included in the second channel structure (CS2). The second wordline (WL2) may extend in a direction (D1) perpendicular to a direction (D2).

The plurality of second channel structures (CS2) repeatedly arranged in the first direction (D1) may be connected to one second wordline (WL2).

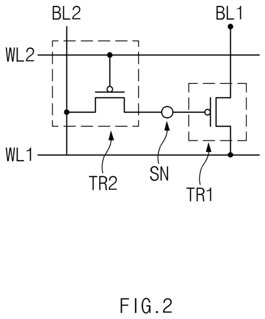

FIG. 2 is a circuit diagram illustrating an example of an equivalent circuit of a memory cell based on some embodiments of the present disclosure.

In FIG. 2, the connection relationship between the first transistor (TR1), the storage node (SN), and the second transistor (TR2) is illustrated.

The structure and the operating method of the memory cell based on some embodiments of the present disclosure will hereinafter be described with reference to FIGS. 1 and 2.

The second transistor (TR2) may include a second wordline (WL2) and a second bitline (BL2). In addition, the second transistor (TR2) may include a second gate, a second gate insulation layer, and a second channel region.

In some embodiments, the second gate may be connected to the second wordline (WL2), and one side of the second channel region may be connected to the second bitline (BL2).

The other side of the second channel region may be connected to the storage node (SN). The storage node (SN) may be disposed between the first transistor (TR1) and the second transistor (TR2), and may be a region in which the second channel region included in the second transistor (TR2) is connected to the first gate included in the first transistor (TR1).

The first transistor (TR1) may include a first wordline (WL1) and a first bitline (BL1). In addition, the first transistor (TR1) may include a first gate, a first gate insulation layer, and a first channel region.

In some embodiments, the first gate may be connected to the storage node (SN). In addition, the first wordline (WL1) may be connected to one side of the first channel region, and the first bitline (BL1) may be connected to the other side of the first channel region.

A semiconductor device including the first transistor (TR1) and the second transistor (TR2) may operate as a memory device.

When a signal having an activation level is provided to the second gate through the second wordline (WL2), the second transistor (TR2) may be turned on. When the second transistor (TR2) is turned on, a change in the amount of charges stored in the storage node (SN) may occur due to the voltage provided to the second bitline (BL2). At this time, the type of data to be stored in the storage node (SN) may be determined according to the voltage provided to the second bitline (BL2). The above-described operation may be referred to as a write operation.

A voltage to be output from the first transistor (TR1) may change depending on charges stored in the storage node (SN).

In a situation where an arbitrary voltage is provided to the first wordline (WL1) and the first bitline (BL1) is in a precharged state, when charges having the voltage of an activation level are stored in the storage node (SN), a precharge voltage of the first bitline (BL1) may vary according to the voltage provided by the first wordline (WL1).

On the other hand, when such charges having the voltage of the activation level are not stored in the storage node (SN), the precharge voltage of the first bitline (BL1) may not vary according to the voltage provided by the first wordline (WL1).

Therefore, the type of data stored in the storage node (SN) can be confirmed by detecting a voltage change of the first bitline (BL1). The above-described operation may be referred to as a read operation.

One storage node (SN) may correspond to one memory cell. As the first transistors (TR1) and the second transistors (TR2) are selectively operated, different types of data may be stored or read in the respective memory cells.

Parasitic capacitance may occur between the storage node (SN) and a first wordline (WL1) adjacent to the storage node (SN), and parasitic capacitance may occur between the storage node (SN) and the first bitline (BL1) adjacent to the storage node (SN). In addition, parasitic capacitance may occur between the storage node (SN) and the second wordline (WL2) adjacent to the storage node (SN), and parasitic capacitance may occur between the storage node (SN) and the second bitline (BL2) adjacent to the storage node (SN).

A voltage drop of the storage node (SN) may occur due to parasitic capacitance. For example, a voltage change of the storage node (SN) may occur due to either a voltage change of the first wordline (WL1) or a voltage change of the second wordline (WL2). As a result, as the parasitic capacitance increases, the voltage change may also increase.

When a voltage drop occurs in the storage node (SN), a sensing margin of the semiconductor device may decrease, resulting in deterioration of the operation characteristics of the memory element.

Therefore, a structure may be required to reduce the parasitic capacitance between the storage node (SN) and the adjacent first wordline (WL1), the parasitic capacitance between the storage node (SN) and the adjacent first bitline (BL1), the parasitic capacitance between the storage node (SN) and the second wordline (WL2), and the parasitic capacitance between the storage node (SN) and the second bitline (BL2).

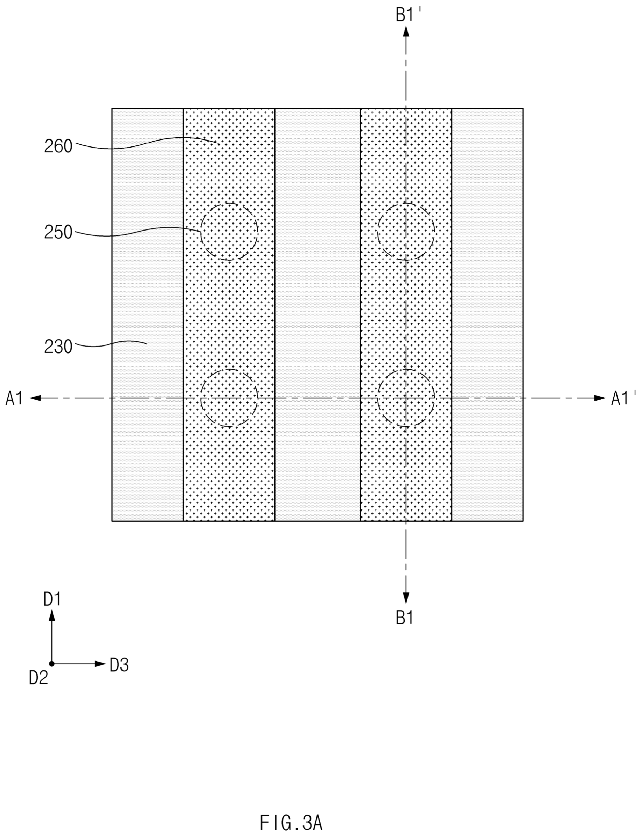

FIG. 3A is a plan view illustrating a portion of a memory cell array when viewed from a second direction based on some embodiments of the present disclosure.

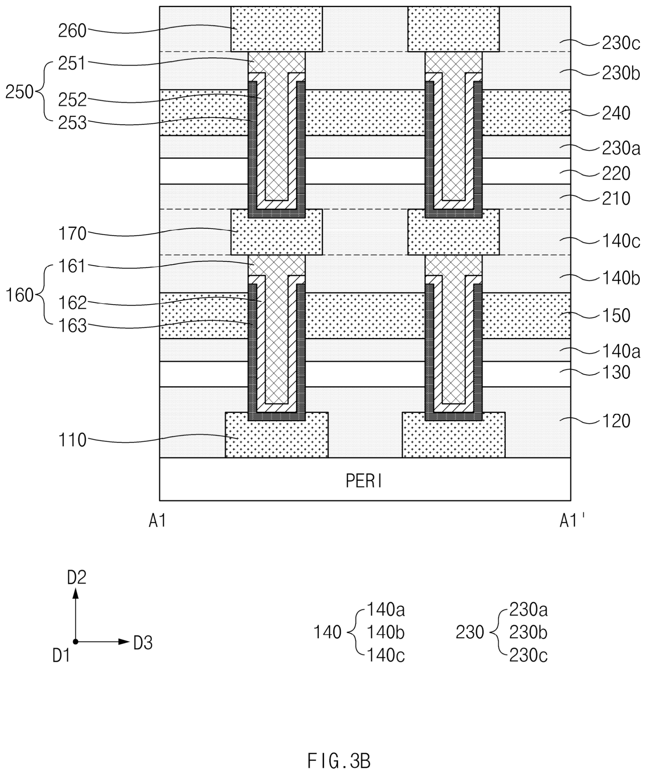

FIG. 3B is a cross-sectional view illustrating an example of a memory cell taken along a first cutting line (A1-A1') of FIG. 3A based on some embodiments of the present disclosure.

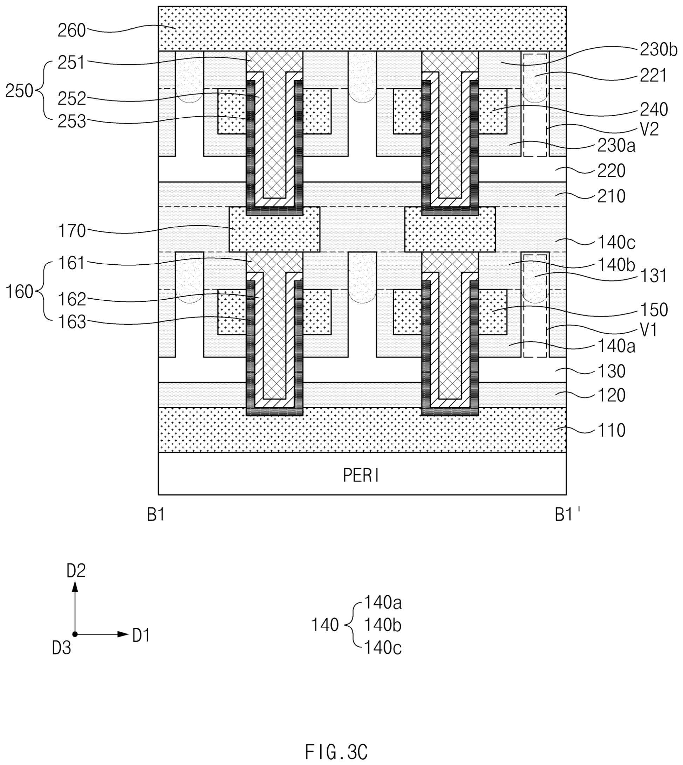

FIG. 3C is a cross-sectional view illustrating an example of a memory cell taken along a second cutting line (B1-B1') of FIG. 3A based on some embodiments of the present disclosure.

In some embodiments, the first cutting line (A1-A1') may be a cutting line extending in the third direction (D3). In addition, the second cutting line (B1-B1') may be a cutting line extending in the first direction (D1).

Hereinafter, a structure of the semiconductor device based on some embodiments of the present disclosure will be described with reference to FIGS. 3A, 3B, and 3C.

Referring to FIGS. 3A to 3C, the semiconductor device based on some embodiments of the present disclosure may include a first wordline 110 disposed over a peripheral region (PERI).

The peripheral region (PERI) may be a region in which a plurality of transistors and a plurality of control circuits are provided. The transistors and the control circuits included in the peripheral region (PERI) may be connected to memory cells located above the peripheral region (PERI) through at least one vertical contact.

A structure in which the peripheral region (PERI) is disposed below a memory cell may be referred to as a peripheral under cell (PUC) structure.

The first wordline 110 may extend in the first direction (D1). The first wordline 110 may include a plurality of layers. For example, the first wordline 110 may include metal, metal nitride, polysilicon, a combination thereof, or multilayers thereof.

The first wordline 110 may be surrounded by a first insulation layer 120, and a plurality of adjacent first wordlines 110 may be electrically isolated from each other by the first insulation layer 120. The first insulation layer 120 may include an insulation material such as silicon nitride.

A first air layer 130 may be disposed over the first insulation layer 120. The first air layer 130 may be a region including air.

The first air layer 130 may open at least a portion of a side surface of the first channel structure 160.

Referring to FIG. 3C, the first air layer 130 may include a first vertical extension portion (V1) disposed between two adjacent first bitlines 150 and extending in a third direction (D3).

In addition, the first air layer 130 may include a first gapfill region 131 disposed within the first vertical extension portion (V1). The first gapfill region 131 may extend in the third direction (D3).

The first gapfill region 131 may include silicon oxide manufactured through a Spin on Dielectric (SOD) process.

As the first air layer 130 including air is formed, parasitic capacitance that may occur between the storage node 170 and the first wordline 110 may be reduced.

In addition, parasitic capacitance that may occur between the first bitlines 150 may be reduced by the first vertical extension portion (V1) included in the first air layer 130.

A second insulation layer 140 may be disposed over the first air layer 130. The second insulation layer 140 may surround the side surfaces of the first channel structure 160, the first bitlines 150, and the storage node 170.

In some embodiments, the second insulation layer 140 may include an insulation material such as silicon nitride.

The second insulation layer 140 may include, for example, a lower end (140a) of the second insulation layer (hereinafter referred to as a "second insulation layer lower end"), a middle end (140b) of the second insulation layer (hereinafter referred to as a "second insulation layer middle end"), and an upper end (140c) of the second insulation layer (hereinafter referred to as a "second insulation layer upper end").

The second insulation layer lower end (140a), the second insulation layer middle end (140b), and the second insulation layer upper end (140c) may include the same insulation material or different insulation materials. As the second insulation layer 140 is provided, the first bitlines 150 adjacent to each other, the first channel structures 160, and the storage nodes 170 may be electrically isolated from each other.

The first bitlines 150 may be disposed in the second insulation layer 140, and may extend in the third direction (D3). Each of the first bitlines 150 may include a plurality of layers. For example, the first bitline 150 may include metal, metal nitride, polysilicon, a combination thereof, or multilayers thereof.

The first bitline 150 may contact the side surfaces of the first channel structure 160. The first bitline 150 may be formed in a shape that surrounds at least a portion of the side surface of the first channel structure 160. The first bitline 150 may contact a first channel region 163 included in the first channel structure 160.

The first channel structure 160 may include a first gate 161 formed in a pillar shape extending in the second direction (D2), a first gate insulation layer 162 surrounding the bottom and side surfaces of the first gate 161, and a first channel region 163 formed to surround the first gate insulation layer 162.

The first gate 161 may include metal, metal nitride, polysilicon, a combination thereof, or multilayers thereof. The first gate 161 may be formed in a shape including the side surface extending in the second direction (D2). For example, the first gate 161 may be formed in a cylindrical shape or a polygonal pillar shape.

The first gate insulation layer 162 may include an insulation material such as silicon oxide.

The first channel region 163 may be disposed over the bottom and side surfaces of the first gate insulation layer 162. The first channel region 163 may include, for example, an oxide semiconductor material.

The oxide semiconductor material may include, for example, indium gallium zinc oxide (IGZO).

According to another embodiment, the first channel region 163 may include doped polysilicon, undoped polysilicon, amorphous silicon, indium zinc oxide (IZO), indium tin oxide (ITO), indium oxide (InO₃), and the like.

The first channel region 163 including the oxide semiconductor material may have low leakage current characteristics.

The storage node 170 may be surrounded by the second insulation layer 140.

The storage node 170 may include, for example, metal, metal nitride, polysilicon, a combination thereof, and/or multilayers thereof. The storage node 170 may electrically connect one first channel structure 160 and one second channel structure 250 to each other.

A third insulation layer 210 may be disposed over the storage node 170. The third insulation layer 210 may include an insulation material such as silicon nitride.

A second air layer 220 may be disposed over the third insulation layer 210. The second air layer 220 may be a region including air.

The second air layer 220 may open at least a portion of the side surface of the second channel structure 250.

Referring to FIG. 3C, the second air layer 220 may include a second vertical extension portion (V2) disposed between two adjacent second bitlines 240 and extending in the third direction (D3).

In addition, the second air layer 220 may include a second gapfill region 221 disposed within the second vertical extension portion (V2). The second gapfill region 221 may extend in the third direction (D3).

The second gapfill region 221 may include silicon oxide manufactured through a Spin on Dielectric (SOD) process.

As the second air layer 220 including air is formed, parasitic capacitance that may occur either between the storage node 170 and the second bitline 240 or between the storage node 170 and the second wordline 260 may be reduced.

In addition, parasitic capacitance that may occur between the second bitlines 240 may be reduced by the second vertical extension portion (V2) included in the second air layer 220.

A fourth insulation layer 230 may be disposed over the second air layer 220. The fourth insulation layer 230 may surround the side surfaces of the second channel structure 250, the second bitline 240, and the second wordline 260.

In some embodiments, the fourth insulation layer 230 may include an insulation material such as silicon nitride.

The fourth insulation layer 230 may include, for example, a lower end (230a) of the fourth insulation layer (hereinafter referred to as a "fourth insulation layer lower end"), a middle end (230b) of the fourth insulation layer (hereinafter referred to as a "fourth insulation layer middle end"), and an upper end (230c) of the fourth insulation layer (hereinafter referred to as a "fourth insulation layer upper end").

The fourth insulation layer lower end (230a), the fourth insulation layer middle end (230b), and the fourth insulation layer upper end (230c) may include the same insulation material or different insulation materials.

As the fourth insulation layer 230 is provided, the second bitlines 240 adjacent to each other, the second channel structures 250, and the second wordlines 260 may be electrically isolated from each other.

The second bitlines 240 may be disposed in the second insulation layer 140, and may extend in the third direction (D3). Each of the second bitlines 240 may include a plurality of layers. For example, the second bitlines 240 may include metal, metal nitride, polysilicon, a combination thereof, or multilayers thereof.

The second bitline 240 may contact the side surfaces of the second channel structure 250. The second bitline 240 may be formed in a shape that surrounds at least a portion of the side surface of the second channel structure 250. The second bitline 240 may contact a second channel region 253 included in the second channel structure 240.

The second channel structure 250 may include a second gate 251 formed in a pillar shape extending in the second direction (D2), a second gate insulation layer 252 formed to surround the bottom and side surfaces of the second gate 251, and a second channel region 253 formed to surround the second gate insulation layer 252.

The second gate 251 may include metal, metal nitride, polysilicon, a combination thereof, or multilayers thereof. The second gate 251 may be formed in a shape that includes the side surface extending in the second direction (D2). For example, the second gate 251 may have a cylindrical shape or a polygonal pillar shape.

The second gate insulation layer 252 may include an insulation material such as silicon oxide.

The second channel region 253 may be disposed on the side and bottom surfaces of the second gate insulation layer 252. The second channel region 253 may include, for example, an oxide semiconductor material.

The oxide semiconductor material may include, for example, indium gallium zinc oxide (IGZO).

According to another embodiment, the second channel region 253 may include doped polysilicon, undoped polysilicon, amorphous silicon, indium zinc oxide (IZO), indium tin oxide (ITO), indium oxide (InO₃), and the like.

The second channel region 253 including the oxide semiconductor material may have low leakage current characteristics.

One or more second wordlines 260 may be disposed over the second channel structure 250. More specifically, the second wordline 260 may be connected to the second gate 251 included in the second channel structure 250.

The second wordline 260 may extend in the first direction (D1). The second wordline 260 may include a plurality of layers. For example, the second wordline 260 may include metal, metal nitride, polysilicon, a combination thereof, or multilayers thereof. The plurality of second wordlines 260 adjacent to each other may be electrically isolated from each other by the fourth insulation layer 230.

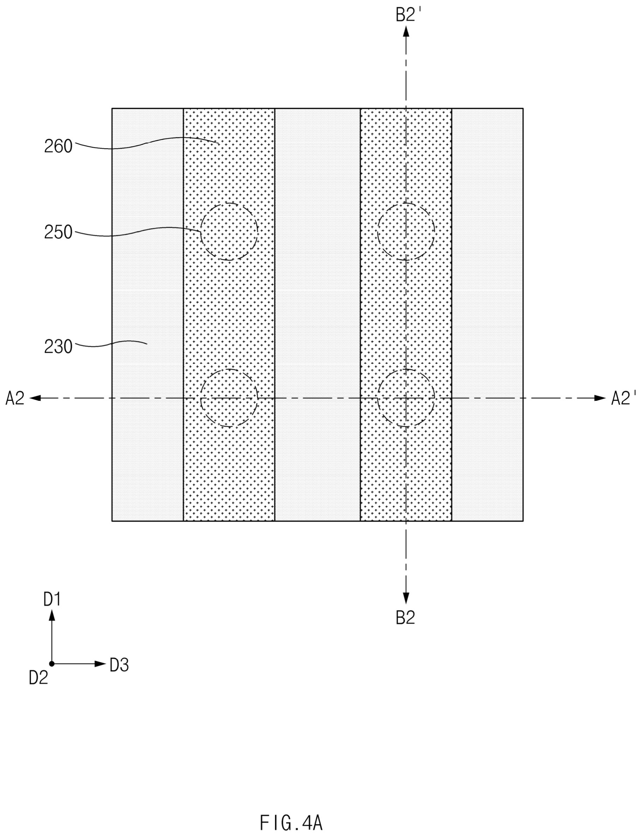

FIG. 4A is a plan view illustrating a portion of the memory cell array when viewed from a second direction based on some other embodiments of the present disclosure.

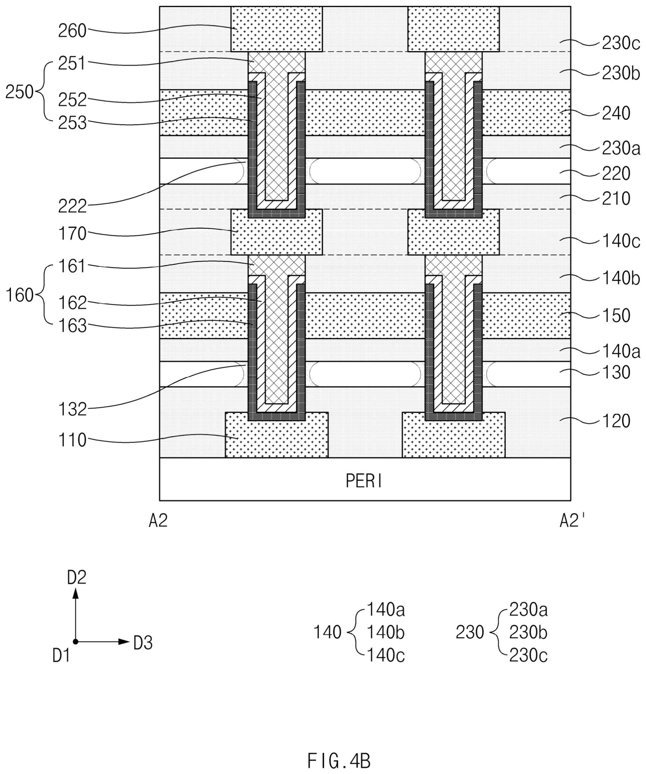

FIG. 4B is a cross-sectional view illustrating an example of the memory cell taken along a third cutting line of FIG. 4A based on some other embodiments of the present disclosure.

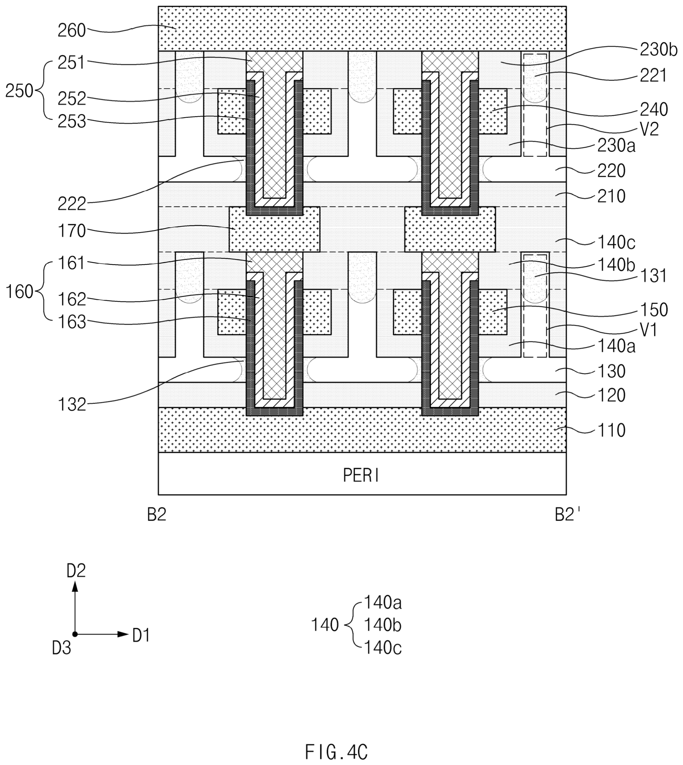

FIG. 4C is a cross-sectional view illustrating an example of the memory cell taken along a fourth cutting line of FIG. 4A based on some other embodiments of the present disclosure.

According to an embodiment, the third cutting line (A2-A2') may be a cutting line extending in the third direction (D3). In addition, the fourth cutting line (B2-B2') may be a cutting line extending in the first direction (D1).

Hereinafter, the structure of the semiconductor device according to one embodiment of the present disclosure will be described with reference to FIGS. 4A, 4B, and 4C.

The remaining internal structures of the semiconductor device shown in FIGS. 4A to 4C with the exception of a first residual sacrificial layer 132 disposed in the first air layer 130 and a second residual sacrificial layer 222 disposed in the second air layer 220 are substantially the same as those of the semiconductor device described with reference to FIGS. 3A to 3C, and as such redundant description thereof will herein be omitted for brevity. The semiconductor devices shown in FIGS 4A to 4C will hereinafter be described with a focus on the residual sacrificial layers (132, 222).

The first residual sacrificial layer 132 is disposed within the first air layer 130, and may surround at least a portion of the side surface of the first channel structure 160.

The first residual sacrificial layer 132 may surround a sidewall of the first channel region 163 included in the first channel structure 160. The first residual sacrificial layer 132 may be formed to contact the sidewall of the first channel structure 160.

The first residual sacrificial layer 132 may include a carbon-containing material such as spin on carbon (SOC).

The first residual sacrificial layer 132 may be formed by selectively removing the spin-on carbon (SOC) layer when the first air layer 130 is formed through a plasma process.

In this case, the plasma process may be carried out using gas (e.g., oxygen (O₂), nitrogen (N₂), hydrogen (H₂), carbon monoxide (CO), carbon dioxide (CO₂), or methane (CH₄)) including at least one of oxygen, nitrogen, or hydrogen.

For example, if the O₂ plasma process is carried out, oxygen radicals (O*) may be combined with carbons of the sacrificial layer, resulting in formation of CO or CO₂. The generated CO or CO₂ may be discharged to the outside through the first vertical extension portion (V1), so that the sacrificial layer pattern can be removed and the first air layer 130 can be formed.

At this time, information as to whether or not the sacrificial layer pattern remains may be adjusted by controlling an execution time and temperature of the plasma process or gas to be used for the plasma process.

The second residual sacrificial layer 222 may be disposed within the second air layer 220, and may surround at least a portion of the side surface of the second channel structure 250. The second residual sacrificial layer 222 may be formed to contact the sidewall of the second channel structure 250.

The second residual sacrificial layer 222 may surround the sidewall of the second channel region 253 included in the second channel structure 250.

The second residual sacrificial layer 222 may include a carbon-containing material such as spin on carbon (SOC).

The second residual sacrificial layer 222 may be formed by selectively removing the spin-on carbon (SOC) layer when forming the second air layer 220 through the plasma process, and the manufacturing process of the second residual sacrificial layer 222 is substantially the same as the manufacturing process of the first residual sacrificial layer 132 described above, and as such redundant description thereof will herein be omitted for brevity.

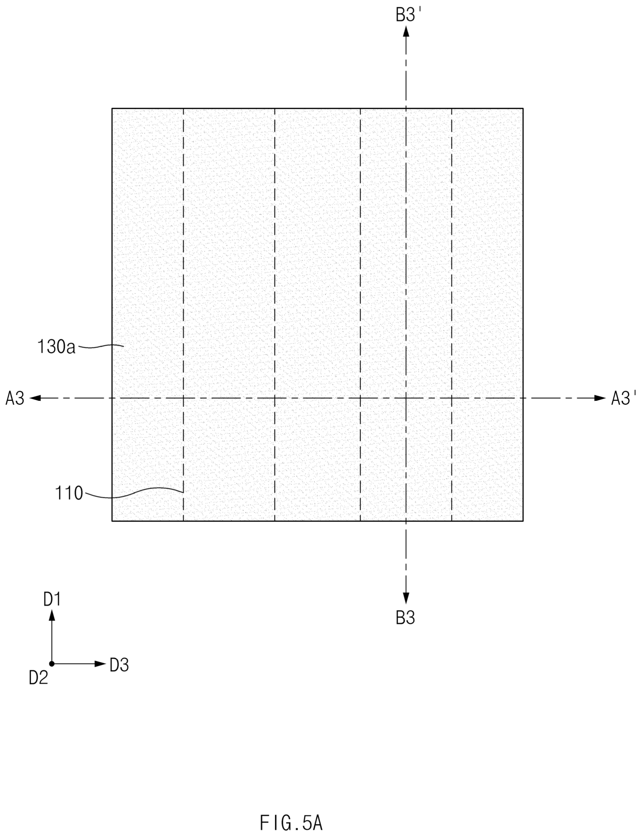

A method for manufacturing the semiconductor device according to an embodiment of the present disclosure will hereinafter be described with reference to FIGS. 5A to 26C.

FIGS. 5A to 5C are diagrams illustrating examples of a method for manufacturing a first wordline of the semiconductor device according to an embodiment of the present disclosure.

FIG. 5A is a plan view illustrating a method for manufacturing a memory cell array when viewed from the second direction according to an embodiment of the present disclosure.

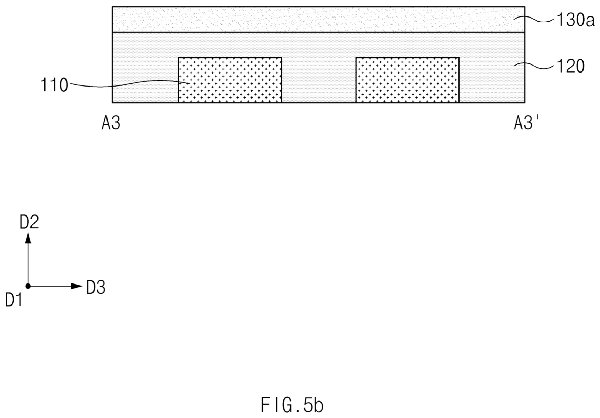

FIG. 5B is a cross-sectional view illustrating an example of the memory cell array taken along a fifth cutting line (A3-A3') shown in FIG. 5A.

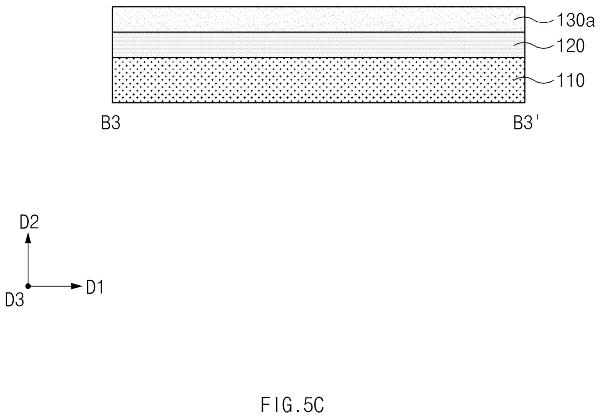

FIG. 5C is a cross-sectional view illustrating an example of the memory cell array taken along a sixth cutting line (B3-B3') shown in FIG. 5A.

FIGS. 5A to 5C are diagrams illustrating examples of a method for forming the first sacrificial layer over the first wordline.

Referring to FIGS. 5A to 5C, a first insulation layer 120 may be formed over the first wordline 110, and a first sacrificial layer (130a) may be formed over the first insulation layer 120.

Although not shown in the drawings, the first wordlines 110 may be formed over a substrate suitable for semiconductor processing.

For example, the substrate may be formed of a semiconductor material containing silicon. The substrate may include silicon, monocrystalline silicon, polysilicon, amorphous silicon, silicon germanium, monocrystalline silicon germanium, polycrystalline silicon germanium, carbon-doped silicon, a combination thereof, or multilayers thereof.

The substrate may also include other semiconductor materials such as germanium. The substrate may include a group III/V semiconductor substrate, for example, a compound semiconductor substrate such as gallium arsenide (GaAs).

The substrate may include a silicon on insulator (SOI) substrate.

In another embodiment, the substrate may include a peripheral circuit region (not shown) located at a lower portion thereof.

The first wordline 110 may extend in the first direction (D1).

The first wordline 110 may include metal, metal nitride, polysilicon, a combination thereof, or multilayers thereof.

The first insulation layer 120 may overlap the first wordlines 110 formed on the substrate. The first insulation layer 120 may include silicon nitride.

The first sacrificial layer (130a) may be formed to overlap the entire upper portion of the first insulation layer 120. The region where the first sacrificial layer (130a) is formed may be a region to be used as the first air layer 130 through the plasma process.

The first sacrificial layer (130a) may include a carbon-containing material. For example, the first sacrificial layer (130a) may include spin on carbon (SOC).

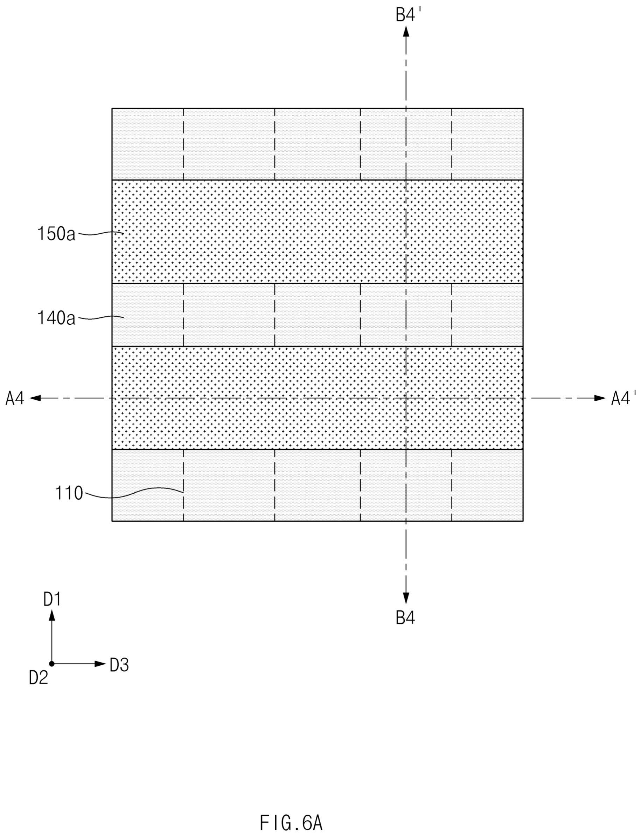

FIGS. 6A to 6C are diagrams illustrating examples of a method for forming a second insulation layer lower end and a first pre-bitline over the first sacrificial layer (130a).

FIG. 6A is a plan view illustrating an example of a method for manufacturing the memory cell array when viewed from the second direction according to an embodiment of the present disclosure.

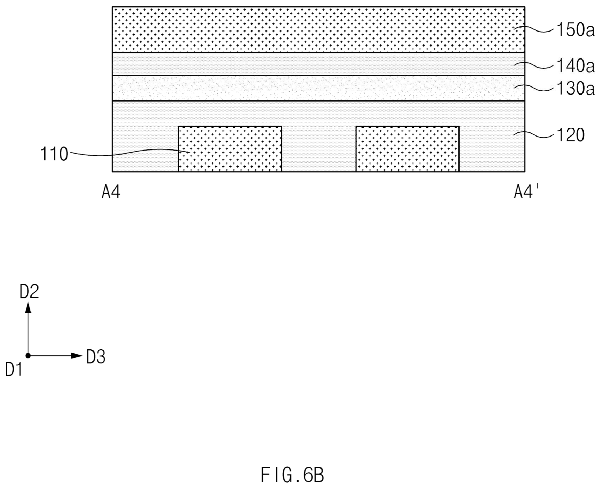

FIG. 6B is a cross-sectional view illustrating an example of the memory cell array taken along a seventh cutting line (A4-A4') shown in FIG. 6A.

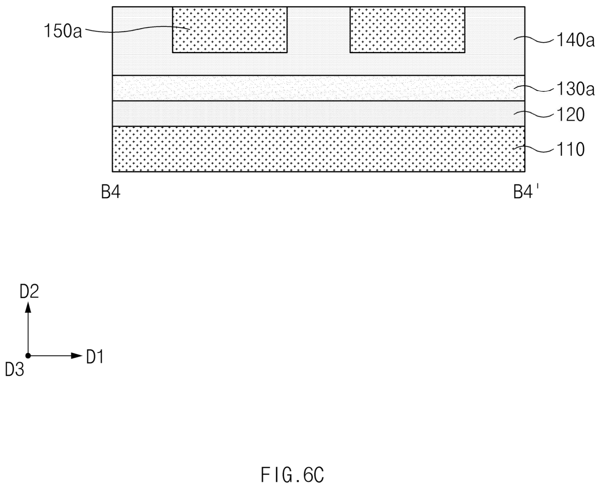

FIG. 6C is a cross-sectional view illustrating an example of the memory cell array taken along an eighth cutting line (B4-B4') shown in FIG. 6A.

Referring to FIGS. 6A to 6C, a second insulation layer lower end (140a) may be formed over the first sacrificial layer (130a), and a first pre-bitline (150a) may be formed in the second insulation layer lower end (140a).

The second insulation layer lower end (140a) may be a region including silicon nitride. Then, the second insulation layer lower end (140a) may be a region included in the second insulation layer 140.

The first pre-bitline (150a) may be formed by etching a portion of the second insulation layer lower end (140a) and depositing a conductive material. The first pre-bitline (150a) may include metal, metal nitride, polysilicon, a combination thereof, or multilayers thereof.

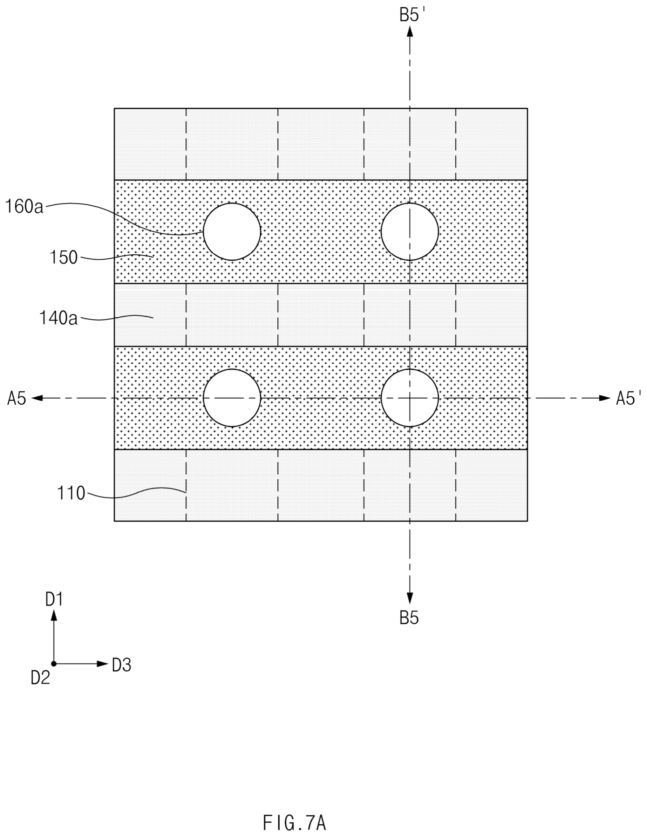

FIGS. 7A to 7C are diagrams illustrating examples of a method for forming first channel holes (160a).

FIG. 7A is a plan view illustrating an example of a method for manufacturing the memory cell array when viewed from the second direction (D2) according to an embodiment of the present disclosure.

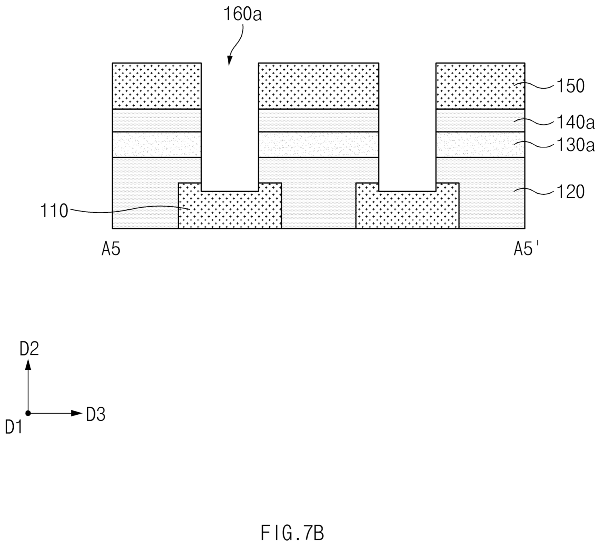

FIG. 7B is a cross-sectional view illustrating an example of the memory cell array taken along a ninth cutting line (A5-A5') shown in FIG. 7A.

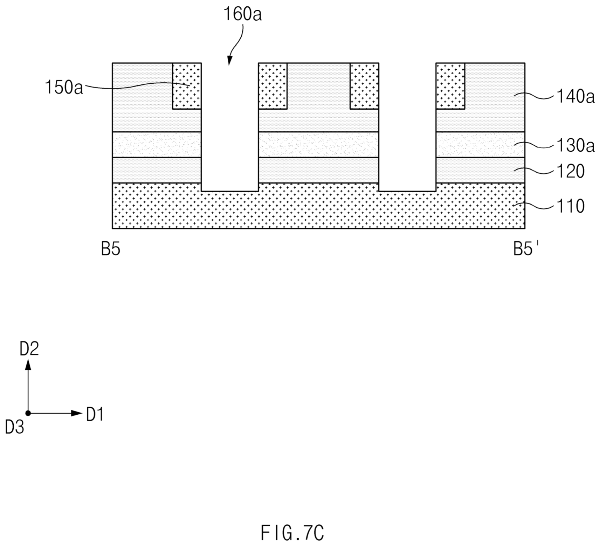

FIG. 7C is a cross-sectional view illustrating an example of the memory cell array taken along a tenth cutting line (B5-B5') shown in FIG. 7A.

Referring to FIGS. 7A to 7C, one or more first channel holes (160a) may penetrate the first pre-bitline (150a), the second insulation layer lower end (140a), the first sacrificial layer (130a), and at least a portion of the first insulation layer 120.

Each of the first channel holes (160a) may be formed in a pillar shape extending in the second direction (D2) so that the first channel region 163 included in the first channel structure 160 has a Channel-All-Around (CAA) structure.

Referring to FIG. 7A, the first channel hole (160a) may be formed in the first bitline 150. In addition, referring to FIGS. 7B and 7C, the first channel hole (160a) may be formed so that at least a portion of the first wordline 110 is opened.

The first channel region 163 may be connected to the first wordline 110 by opening at least a portion of the first wordline 110. The first channel hole (160a) may be selectively formed through an etching process.

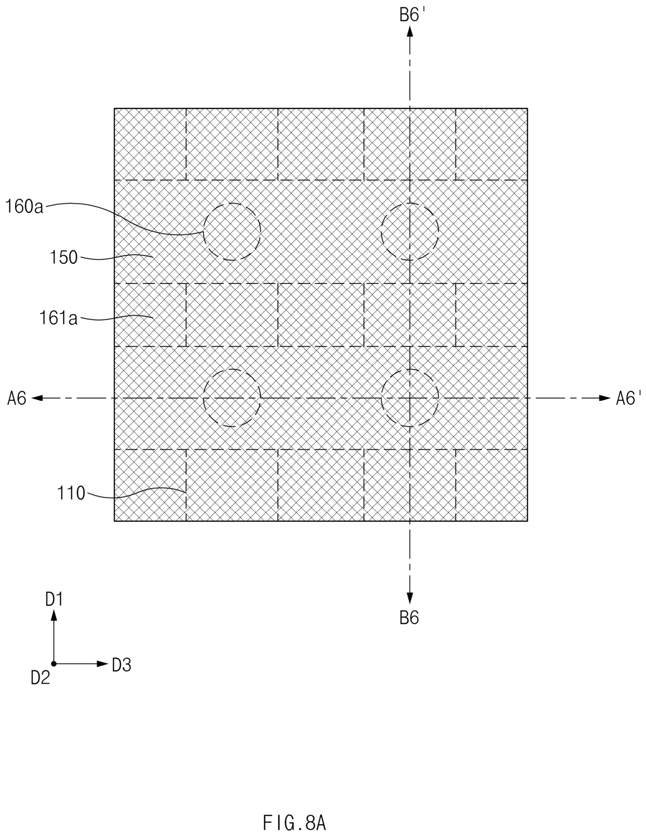

FIGS. 8A to 8C are diagrams illustrating examples of a method for forming a first pre-gate (161a), a first pre-gate insulation layer (162a), and a first pre-channel region (163a) within the first channel hole (160a).

FIG. 8A is a plan view illustrating an example of a method for manufacturing the memory cell array when viewed from the second direction (D2) according to an embodiment of the present disclosure.

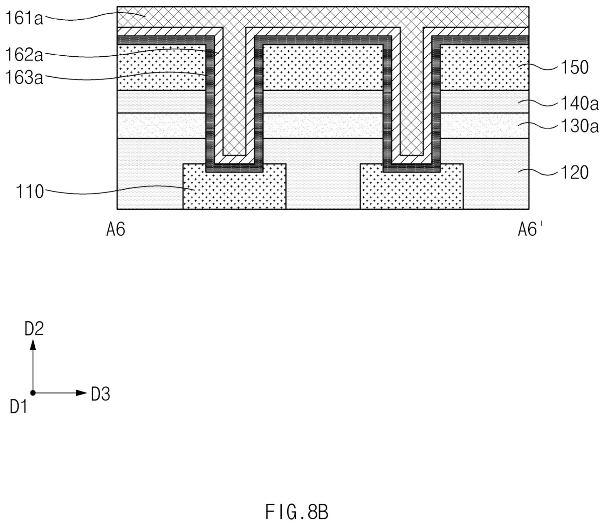

FIG. 8B is a cross-sectional view illustrating an example of the memory cell array taken along the eleventh cutting line (A6-A6') shown in FIG. 8A.

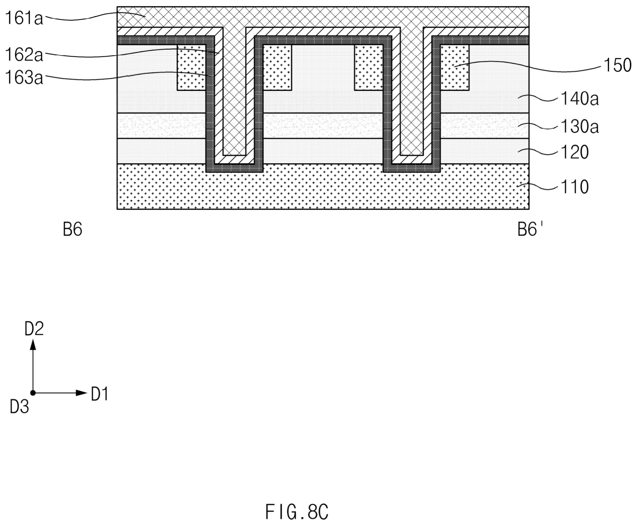

FIG. 8C is a cross-sectional view illustrating an example of the memory cell array taken along the twelfth cutting line (B6-B6') shown in FIG. 8A.

Referring to FIGS. 8A to 8C, a first pre-channel region (163a), a first pre-gate insulation layer (162a), and a first pre-gate (161a) may be sequentially formed within a first channel hole (160a).

The first pre-channel region (163a) may include an oxide semiconductor material, and the oxide semiconductor material may include, for example, indium gallium zinc oxide (IGZO).

The first pre-channel region (163a) may be formed to surround the bottom and side surfaces of the first channel hole (160a). The bottom surface of the first pre-channel region (163a) may contact the first wordline 110, and a portion of the side surface of the first pre-channel region (163a) may contact the first bitline 150.

A first pre-gate insulation layer (162a) may be formed over the first pre-channel region (163a). The first pre-gate insulation layer (162a) may include an insulation material such as silicon oxide.

The first pre-gate (161a) may be formed over the first pre-gate insulation layer (162a). The first pre-gate (161a) may include metal, metal nitride, polysilicon, a combination thereof, or multilayers thereof.

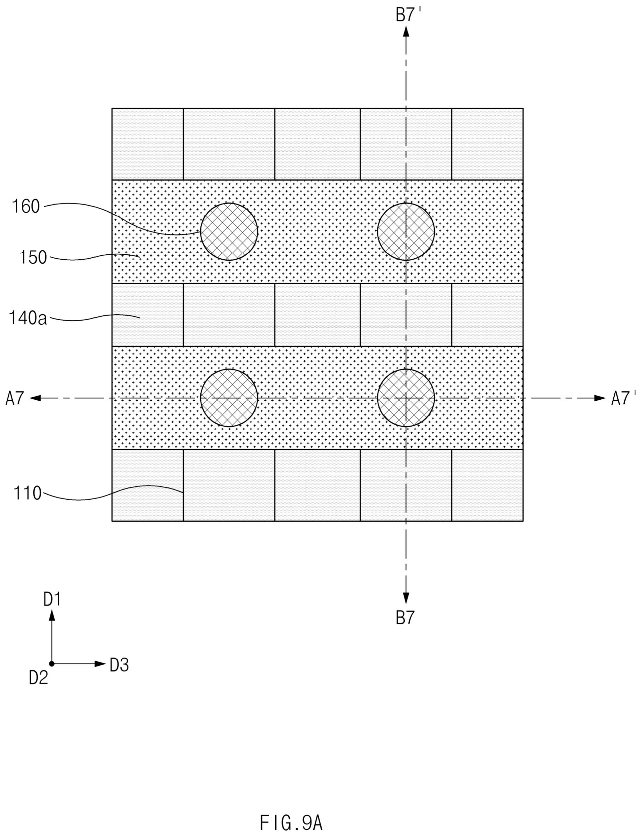

FIGS. 9A to 9C are diagrams illustrating examples of a method for forming the first channel structure 160.

FIG. 9A is a plan view illustrating an example of a method for manufacturing the memory cell array when viewed from the second direction (D2) according to an embodiment of the present disclosure.

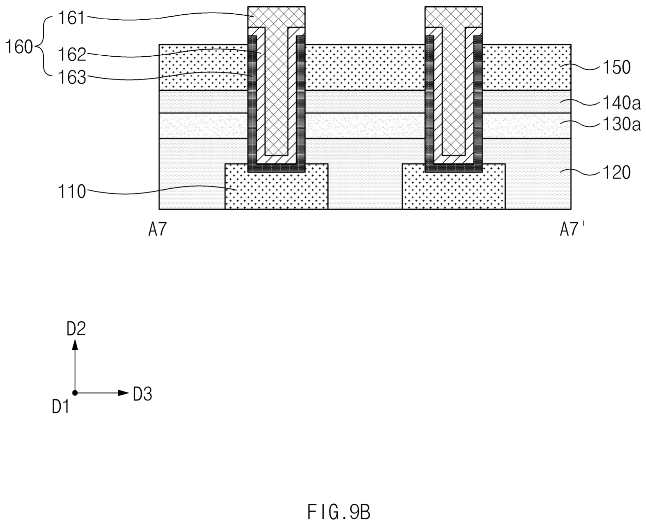

FIG. 9B is a cross-sectional view illustrating an example of the memory cell array taken along the thirteenth cutting line (A7-A7') shown in FIG. 9A.

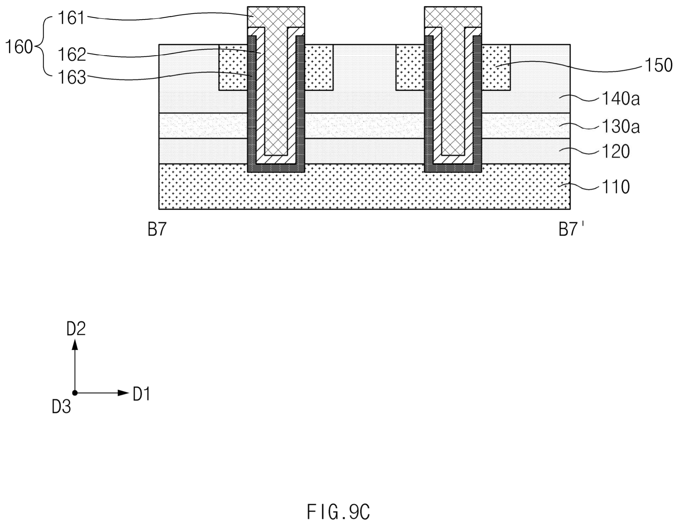

FIG. 9C is a cross-sectional view illustrating an example of the memory cell array taken along the fourteenth cutting line (B7-B7') shown in FIG. 9A.

Referring to FIGS. 9A to 9C, the first channel structure 160 may be formed by selectively removing some regions of a first pre-channel region (163a), a first pre-gate insulation layer (162a), and a first pre-gate (161a).

A plurality of first gates 161 may be electrically isolated from each other by selectively removing some regions of the first pre-channel region (163a), the first pre-gate insulation layer (162a), and the first pre-gate (161a). In addition, the plurality of first channel regions 163 arranged adjacent to each other in the first direction (D1) may be electrically isolated from each other.

On the other hand, a plurality of first channel regions 163 arranged adjacent to each other in the third direction (D3) may be electrically connected to each other (for example, form a common contact) by the first bitlines 150.

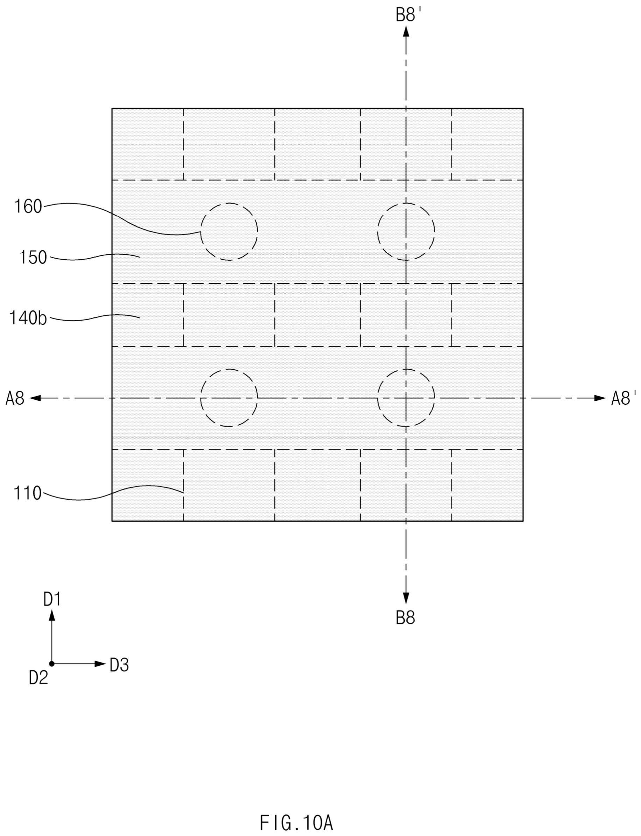

FIGS. 10A to 10C are diagrams illustrating examples of a method for forming the second insulation layer 140.

FIG. 10A is a plan view illustrating an example of a method for manufacturing the memory cell array when viewed from the second direction (D2) according to an embodiment of the present disclosure.

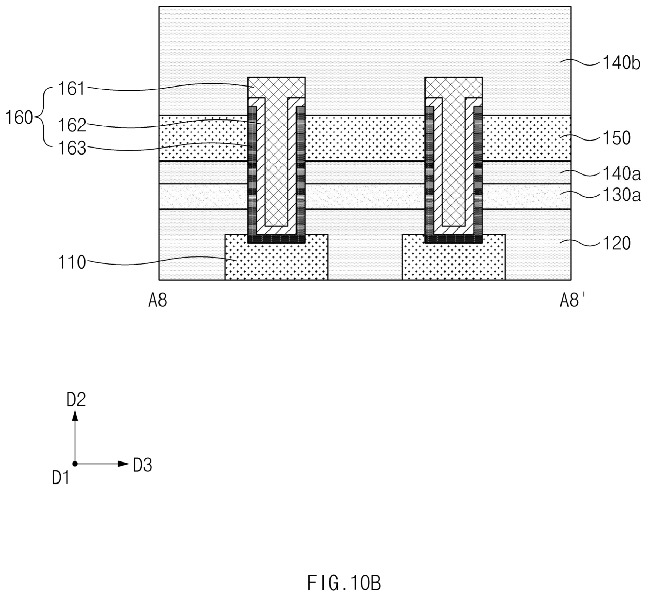

FIG. 10B is a cross-sectional view illustrating an example of the memory cell array taken along the fifteenth cutting line (A8-A8') shown in FIG. 10A.

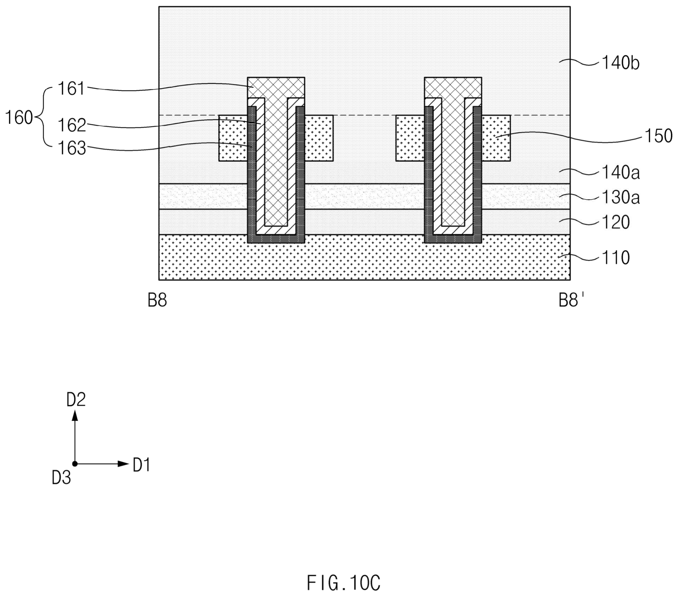

FIG. 10C is a cross-sectional view illustrating an example of the memory cell array taken along the sixteenth cutting line (B8-B8') shown in FIG. 10A.

Referring to FIGS. 10A to 10C, an insulation layer may be additionally deposited on the first channel structure 160 to form a second insulation layer middle end (140b). The second insulation layer middle end (140b) may include an insulation material such as silicon nitride.

The second insulation layer middle end (140b) may be a region included in the second insulation layer 140 to be formed later.

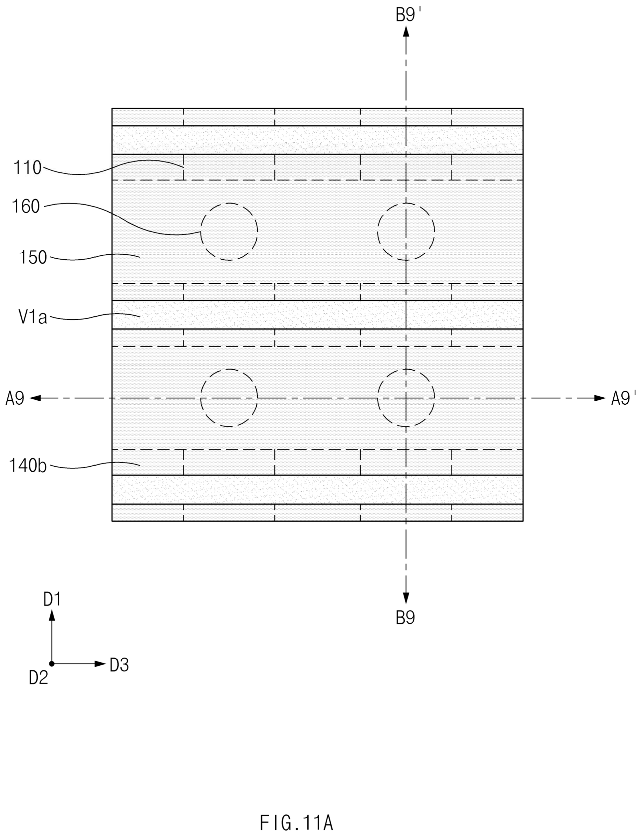

FIGS. 11A to 11C are diagrams illustrating examples of a method for forming a first vertical hole (V1a).

FIG. 11A is a plan view illustrating an example of a method for manufacturing the memory cell array when viewed from the second direction (D2) according to an embodiment of the present disclosure.

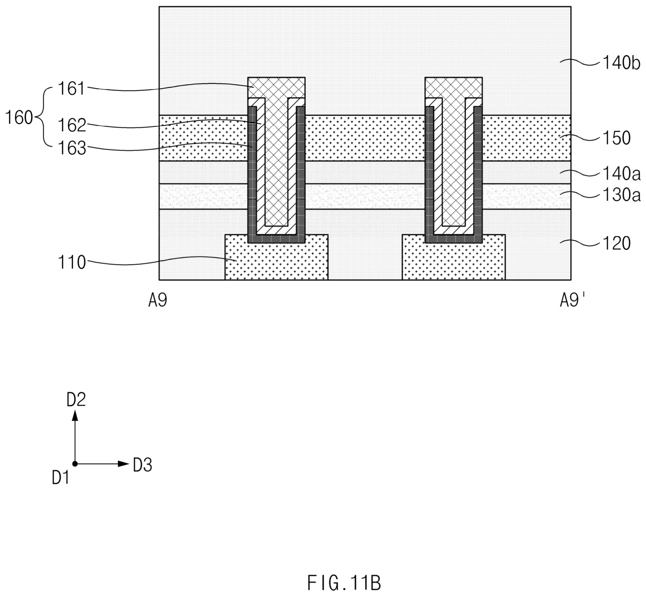

FIG. 11B is a cross-sectional view illustrating an example of the memory cell array taken along the seventeenth cutting line (A9-A9') shown in FIG. 11A.

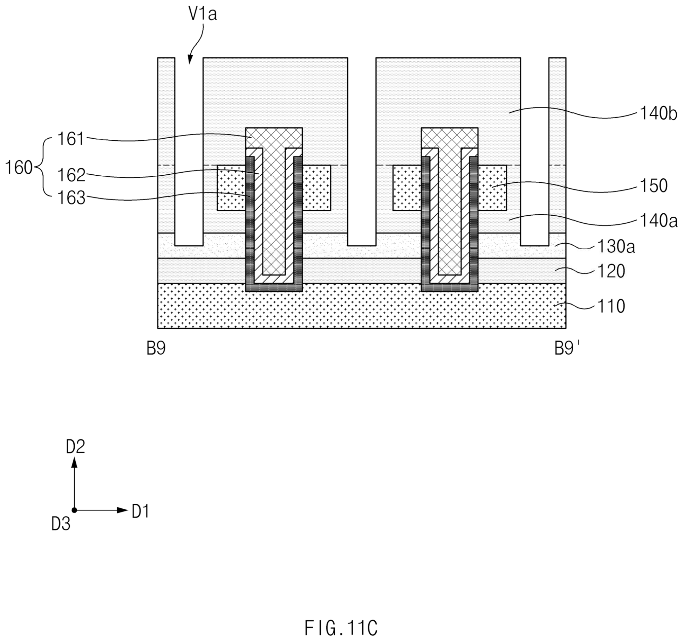

FIG. 11C is a cross-sectional view illustrating an example of the memory cell array taken along the eighteenth cutting line (B9-B9') shown in FIG. 11A.

Referring to FIGS. 11A to 11C, each of the first vertical holes (V1a) may be a region obtained by etching the second insulation layer middle end (140b) and the second insulation layer lower end (140a), and may be a region connected to the first sacrificial layer (130a). The first vertical holes (V1a) may be formed by selectively etching the region between adjacent first bitlines 150. The first vertical holes (V1a) may extend in the third direction (D3).

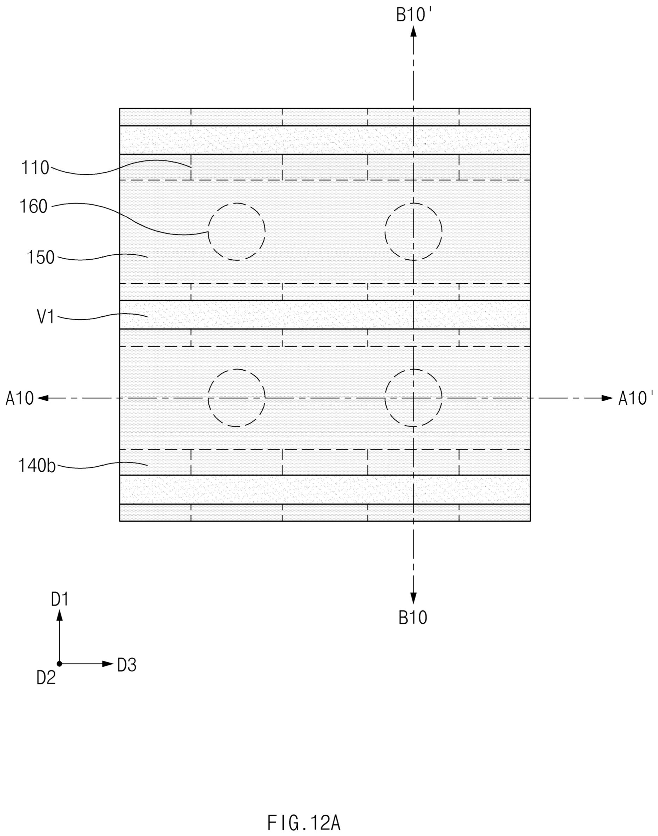

FIGS. 12A to 12C are diagrams illustrating examples of a method for forming the first air layer 130.

FIG. 12A is a plan view illustrating an example of the memory cell array when viewed from the second direction (D2) according to an embodiment of the present disclosure.

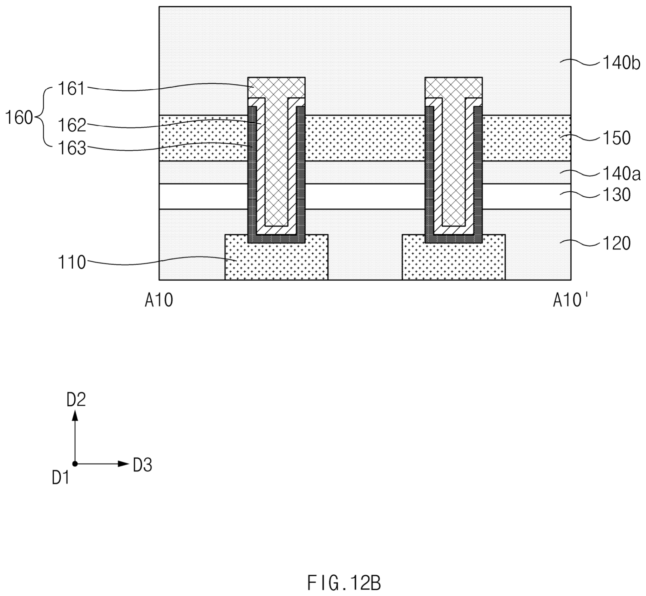

FIG. 12B is a cross-sectional view illustrating an example of the memory cell array taken along the nineteenth cutting line (A10-A10') shown in FIG. 12A.

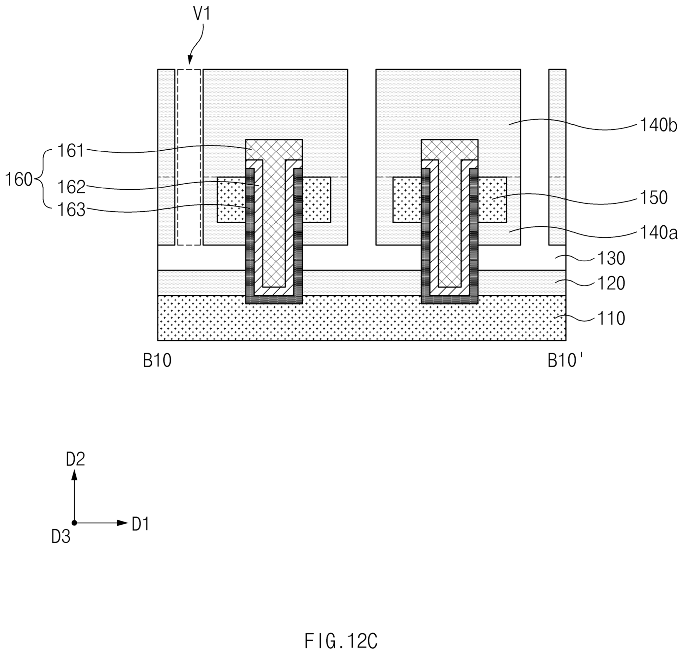

FIG. 12C is a cross-sectional view illustrating an example of the memory cell array taken along the 20^{th} cutting line (B10-B10') shown in FIG. 12A.

Referring to FIGS. 12A to 12C, a process of removing the first sacrificial layer (130a) and forming the first air layer 130 through the plasma process is illustrated.

The plasma process may be carried out using gas (e.g., O₂, N₂, H₂, CO, CO₂, or CH₄) including at least one of oxygen, nitrogen, or hydrogen.

The sacrificial layer (first sacrificial layer (130a)) and the plasma may react with each other, and gas generated through such reaction may be discharged to the outside through the first vertical extension portion (V1). The first air layer 130 may be formed in the region where the first sacrificial layer (130a) is removed.

In some embodiments, the shape of the residual sacrificial layer contacting the sidewall of the first channel region 163 may be adjusted by controlling an execution time and temperature of the plasma process or gas to be used for the plasma process.

For example, when the first sacrificial layer (130a) is completely removed by the plasma process, no residual sacrificial layer may remain in the first air layer 130, as in the embodiments of FIGS. 3A, 3B, and 3C.

On the other hand, when the plasma process is performed so that a portion of the first sacrificial layer (130a) remains, the first residual sacrificial layer 132 may remain in the first air layer 130, as in the embodiments of FIGS. 4A, 4B, and 4C.

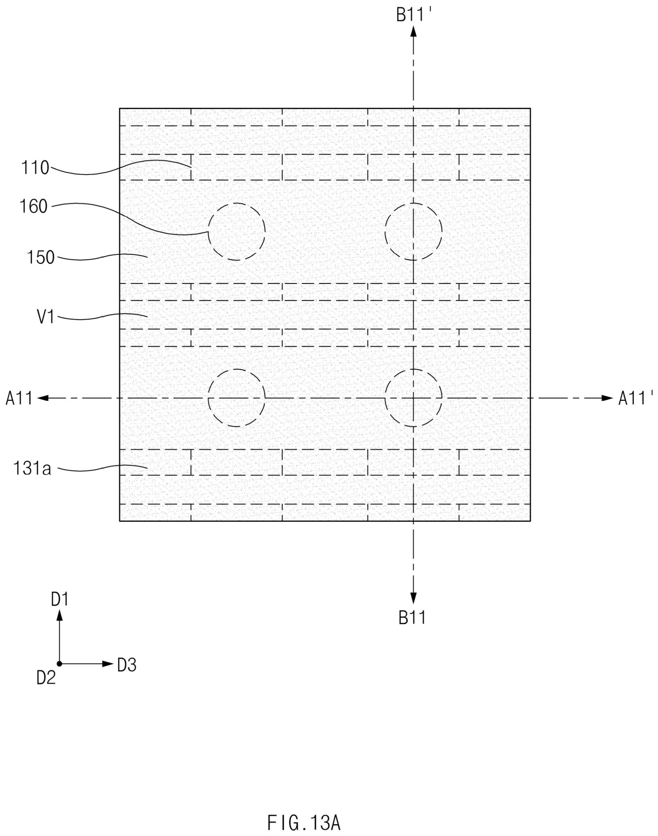

FIGS. 13A to 13C are diagrams illustrating examples of a method for forming a first pre-gapfill region (131a).

FIG. 13A is a plan view illustrating an example of a method for manufacturing the memory cell array when viewed from the second direction (D2) according to one embodiment of the present disclosure.

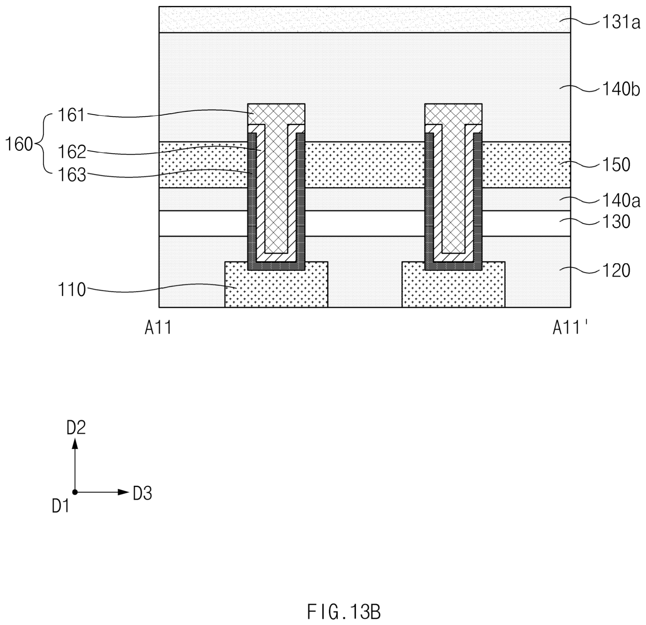

FIG. 13B is a cross-sectional view illustrating an example of the memory cell array taken along the 21^{st} cutting line (A11-A11') of FIG. 13A.

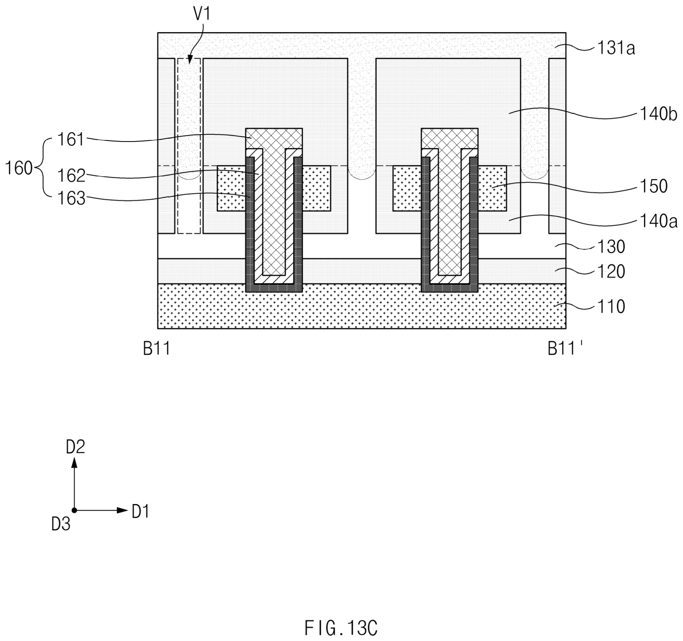

FIG. 13C is a cross-sectional view illustrating an example of the memory cell array taken along the 22^{nd} cutting line (B11-B11') of FIG. 13A.

Referring to FIGS. 13A to 13C, a first pre-gapfill region (131a) may be formed on the second insulation layer 140 through a SOD (Spin on Dielectric) process.

The first pre-gapfill region (131a) may include an insulation material such as silicon oxide.

In some embodiments, the first pre-gapfill region (131a) may extend from the upper portion of the second insulation layer middle end (140b) into the first vertical extension portion (V1) to a depth at which the first bitline 150 is located.

When the first pre-gapfill region (131a) extends to a depth at which the first bitline 150 is located, the first pre-gapfill region (131a) may function as an insulation layer between adjacent first bitlines 150. The first pre-gapfill region (131a) extending between the adjacent first bitlines 150 may reduce parasitic capacitance occurring between the first bitlines 150.

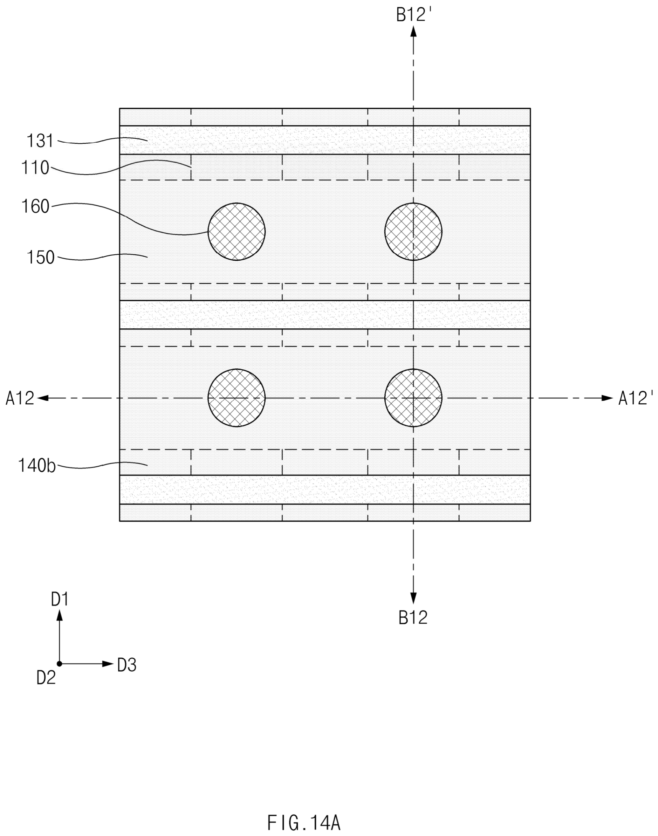

FIGS. 14A to 14C are diagrams illustrating examples of a method for forming the first gapfill region 131.

FIG. 14A is a plan view illustrating an example of a method for manufacturing the memory cell array when viewed from the second direction (D2) according to one embodiment of the present disclosure.

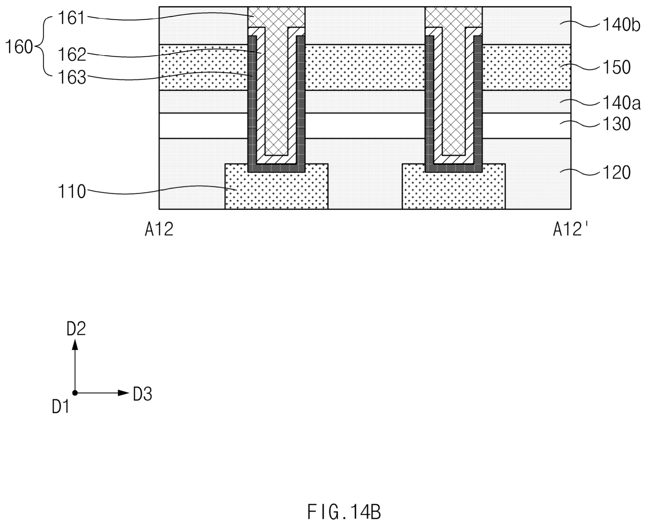

FIG. 14B is a cross-sectional view illustrating an example of the memory cell array taken along the 23^{rd} cutting line (A12-A12') of FIG. 14A.

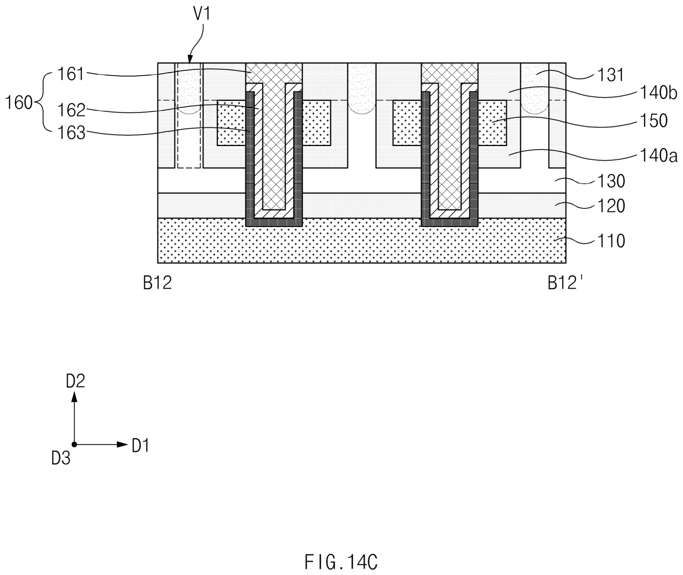

FIG. 14C is a cross-sectional view illustrating an example of the memory cell array taken along the 24^{th} cutting line (B12-B12') of FIG. 14A.

Referring to FIGS. 14A to 14C, a first gapfill region 131 may be formed by removing a portion of the first pre-gapfill region (131a) and a portion of the second insulation layer middle end (140b).

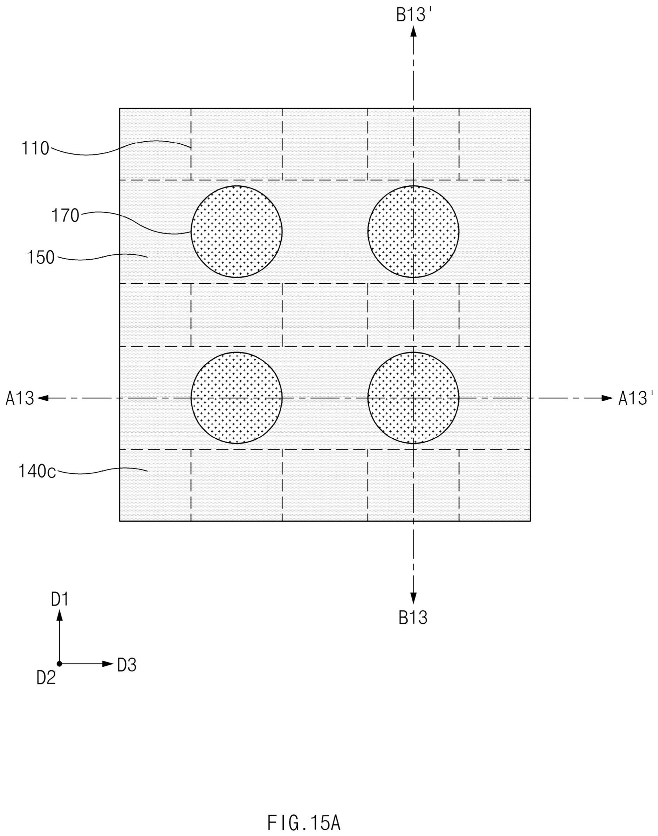

FIGS. 15A to 15C are diagrams illustrating examples of a method for forming one or more storage nodes 170.

FIG. 15A is a plan view illustrating an example of a method for manufacturing the memory cell array when viewed from the second direction (D2) according to an embodiment of the present disclosure.

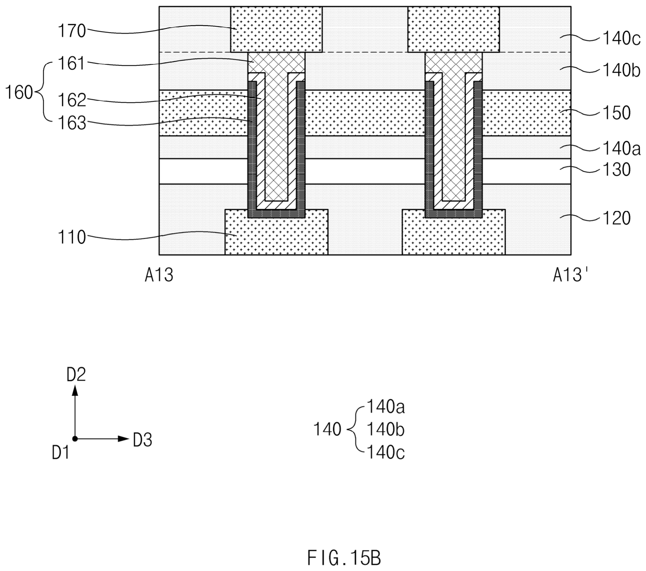

FIG. 15B is a cross-sectional view illustrating an example of the memory cell array taken along the 25^{th} cutting line (A13-A13') of FIG. 15A.

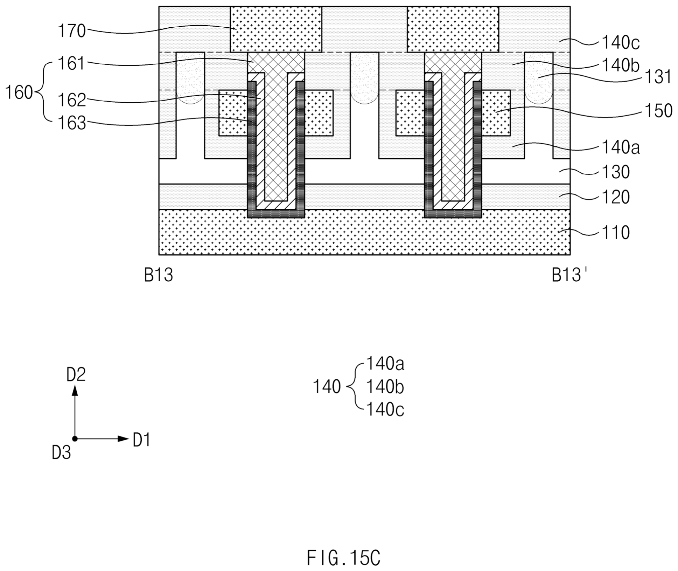

FIG. 15C is a cross-sectional view illustrating an example of the memory cell array taken along the 26^{th} cutting line (B13-B13') of FIG. 15A.

Referring to FIGS. 15A to 15C, each of the storage nodes 170 may be formed over the first gate 161 included in the first channel structure 160.

The storage node 170 may include metal, metal nitride, polysilicon, a combination thereof, or multilayers thereof.

In some embodiments, a second insulation layer upper end (140c) may be additionally formed over the first channel structure 160, and the storage node 170 may be formed within the second insulation layer upper end (140c).

The second insulation layer upper end (140c) may be a region included in the second insulation layer 140.

Some regions of the second insulation layer upper end (140c) are selectively etched so that a region where the storage node 170 will be formed can be defined.

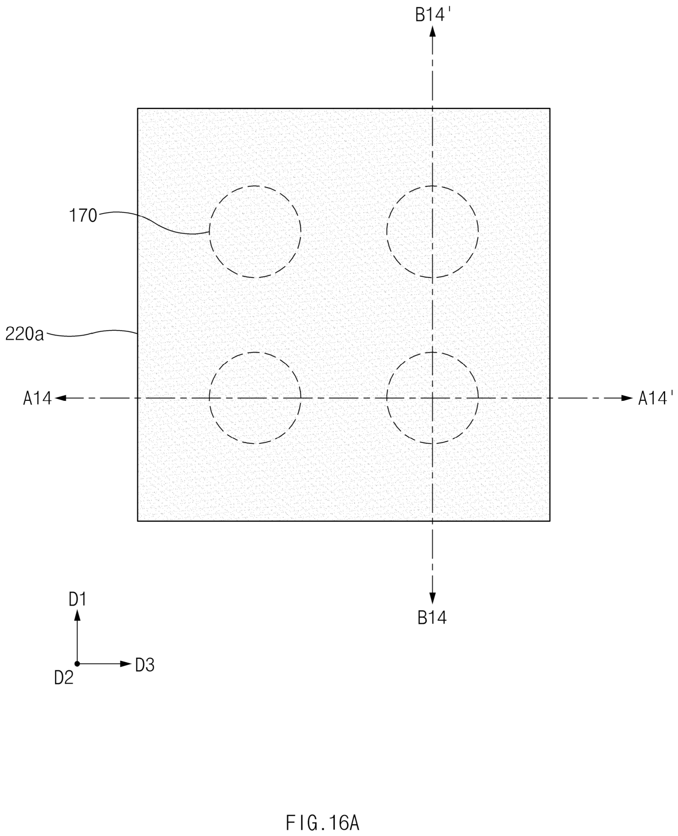

FIGS. 16A to 16C are diagrams illustrating examples of a method for forming a second sacrificial layer (220a) over the storage node 170.

FIG. 16A is a plan view illustrating an example of a method for manufacturing the memory cell array when viewed from the second direction (D2) according to one embodiment of the present disclosure.

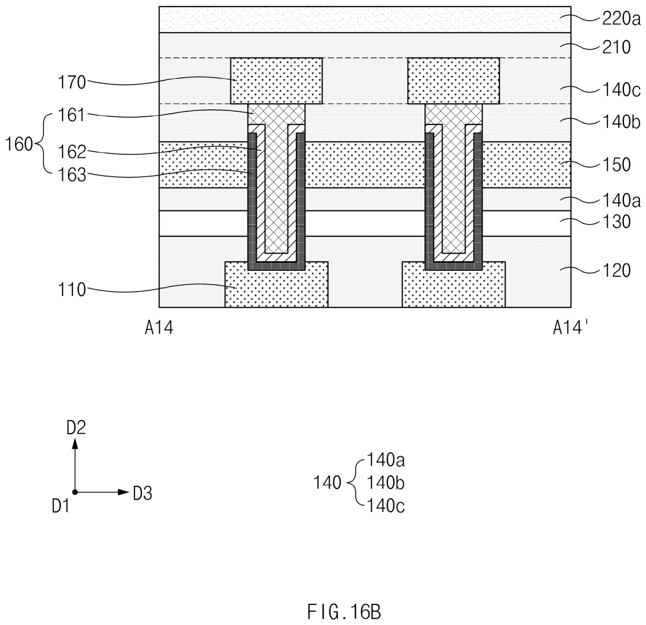

FIG. 16B is a cross-sectional view illustrating an example of the memory cell array taken along the 27^{th} cutting line (A14-A14') of FIG. 16A.

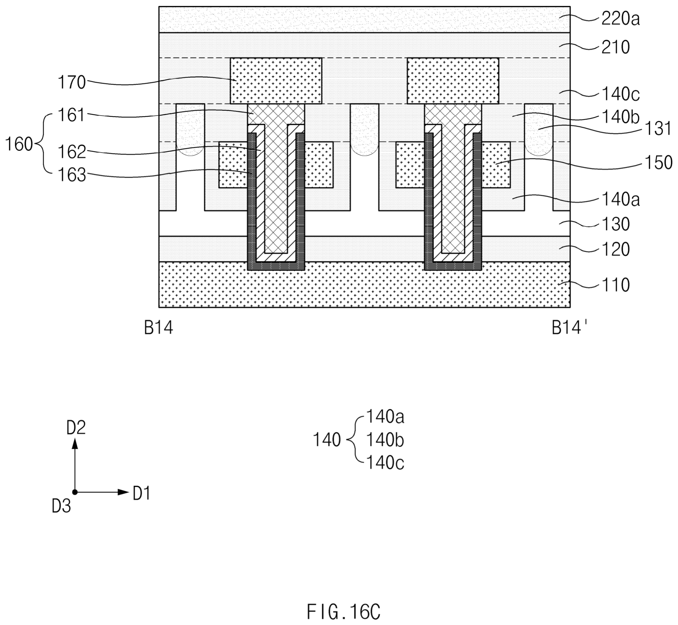

FIG. 16C is a cross-sectional view illustrating an example of the memory cell array taken along the 28^{th} cutting line (B14-B14') of FIG. 16A.

Referring to FIGS. 16A to 16C, a third insulation layer 210 may be formed over the storage node 170, and a second sacrificial layer (220a) may be formed over the third insulation layer 210.

The third insulation layer 210 may include silicon nitride, etc., and the second sacrificial layer (220a) may include a carbon-containing material. For example, the second sacrificial layer (220a) may include spin on carbon (SOC).

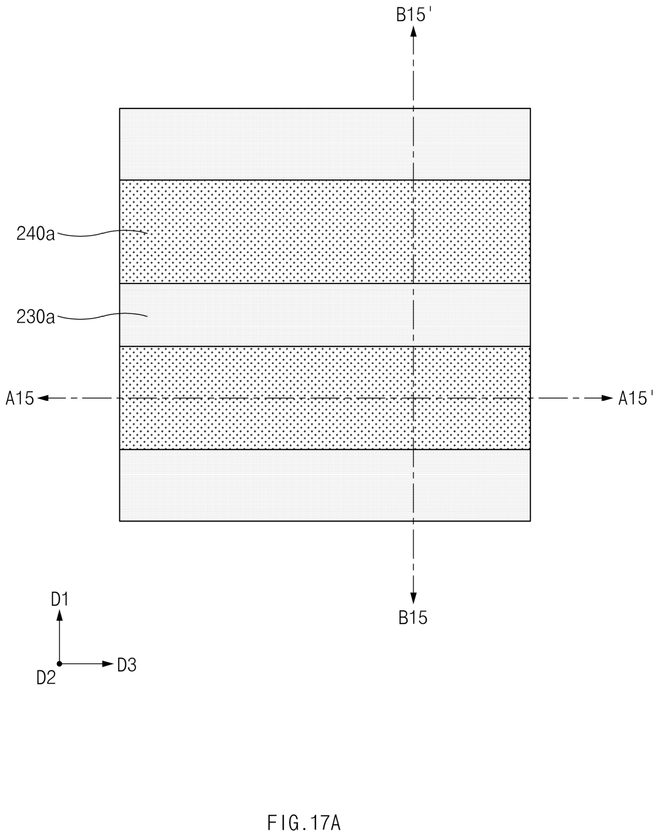

FIGS. 17A to 17C are diagrams illustrating examples of a method for forming a fourth insulation layer lower end (230a) and a second pre-bitline (240a) over the second sacrificial layer (220a).

FIG. 17A is a plan view illustrating an example of a method for manufacturing the memory cell array when viewed from the second direction (D2) according to one embodiment of the present disclosure.

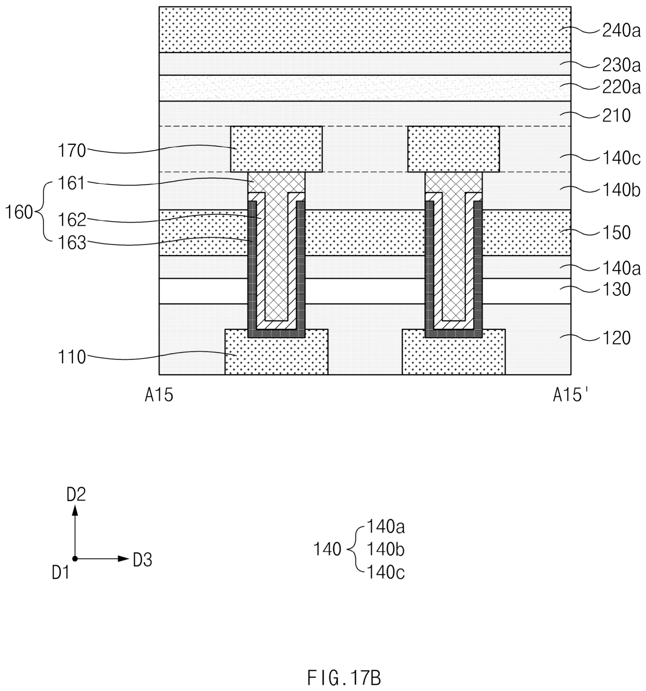

FIG. 17B is a cross-sectional view illustrating an example of the memory cell array taken along the 29^{th} cutting line (A15-A15') of FIG. 17A.

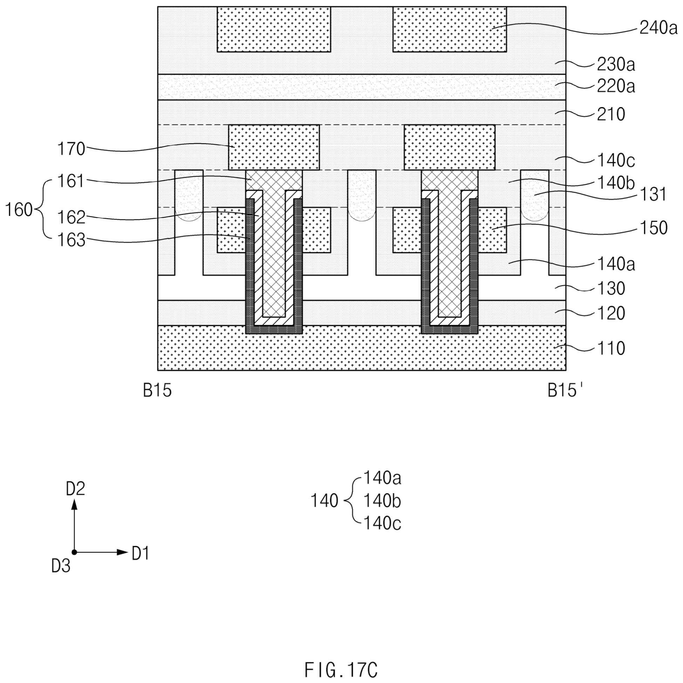

FIG. 17C is a cross-sectional view illustrating an example of the memory cell array taken along the 30^{th} cutting line (B15-B15') of FIG. 17A.

Referring to FIGS. 17A to 17C, a fourth insulation layer lower end (230a) may be formed over the second sacrificial layer (220a), and a second pre-bitline (240a) may be formed in the fourth insulation layer lower end (230a).

The fourth insulation layer lower end (230a) may be a region including silicon nitride, and may then be a region included in the fourth insulation layer 230.

The second pre-bitline (240a) may be formed by etching a portion of the fourth insulation layer lower end (230a) and depositing a conductive material. The second pre-bitline (240a) may include metal, metal nitride, polysilicon, a combination thereof, or multilayers thereof.

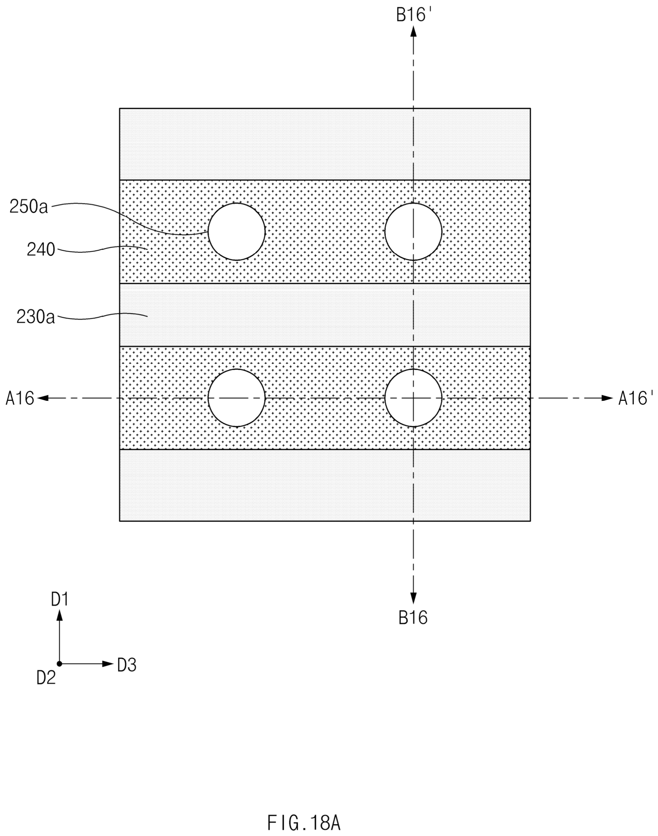

FIGS. 18A to 18C are diagrams illustrating examples of a method for forming a second channel hole (250a).

FIG. 18A is a plan view illustrating an example of a method for manufacturing the memory cell array when viewed from the second direction (D2) according to one embodiment of the present disclosure.

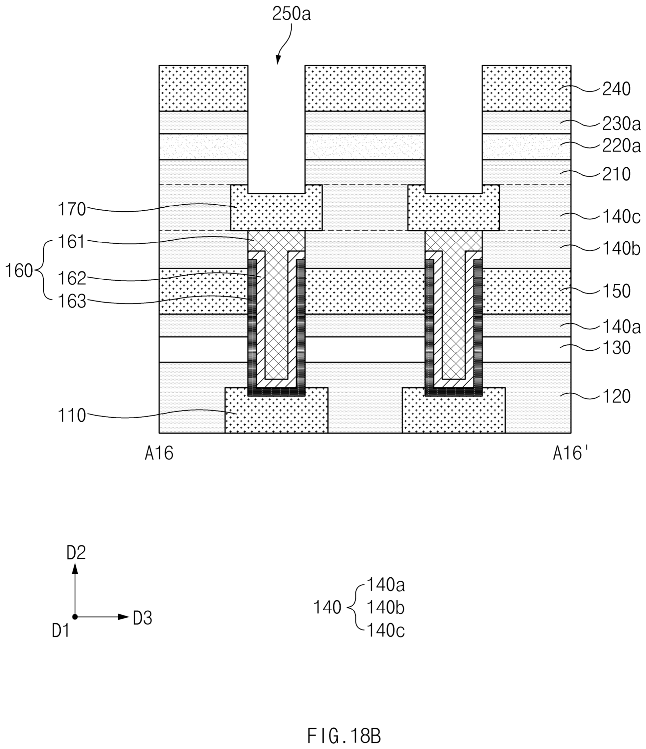

FIG. 18B is a cross-sectional view illustrating an example of the memory cell array taken along the 31^{st} cutting line (A16-A16') of FIG. 18A.

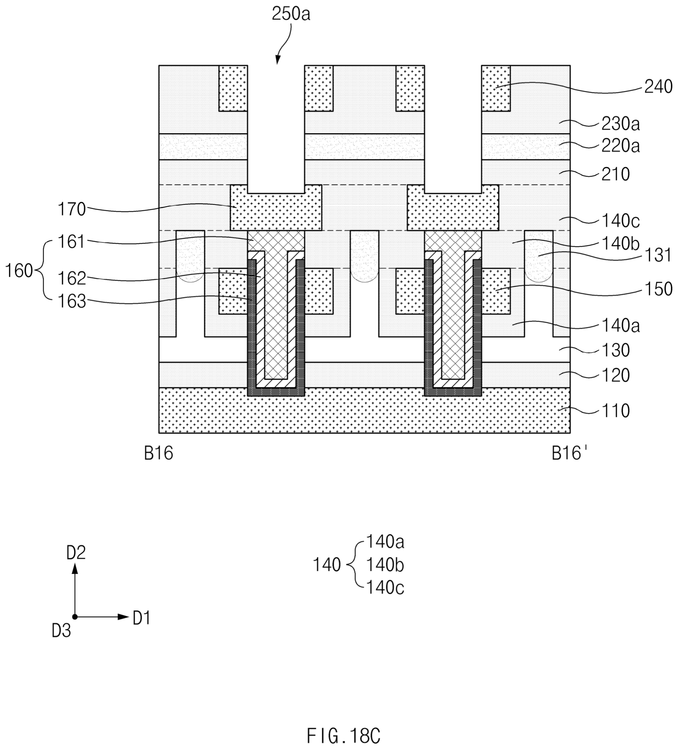

FIG. 18C is a cross-sectional view illustrating an example of the memory cell array taken along the 32^{nd} cutting line (B16-B16') of FIG. 18A.

Referring to FIGS. 18A to 18C, the second channel hole (250a) may penetrate at least a portion of the second pre-bitline (240a), the second insulation layer lower end (230a), the second sacrificial layer (220a), and the third insulation layer 210.

Each of the second channel holes (250a) may be formed in a pillar shape extending in the second direction (D2) so that the second channel region 253 included in the second channel structure 250 has a Channel-All-Around (CAA) structure.

Referring to FIG. 18A, the second channel hole (250a) may be formed in the second bitline 240. In addition, referring to FIGS. 18B and 18C, the second channel hole (250a) may be formed so that at least a portion of the storage node 170 is opened.

The second channel region 253 may be connected to the storage node 170 by opening at least a portion of the storage node 170. The second channel hole (250a) may be selectively formed through the etching process.

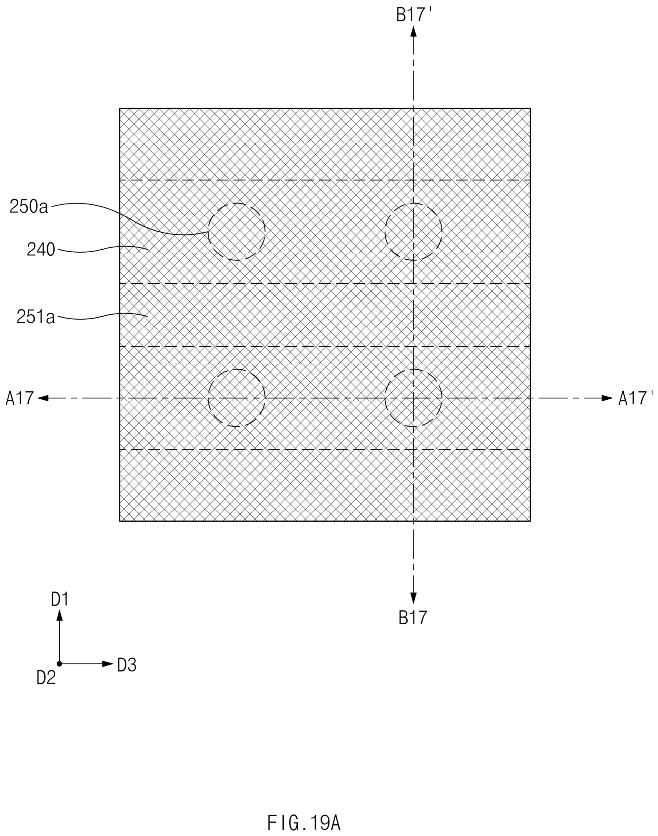

FIGS. 19A to 19C are diagrams illustrating examples of a method for forming a second pre-gate (251a), a second pre-gate insulation layer (252a), and a second pre-channel region (253a) within a second channel hole (250a).

FIG. 19A is a plan view illustrating an example of a method for manufacturing a memory cell array when viewed from the second direction (D2) according to one embodiment of the present disclosure.

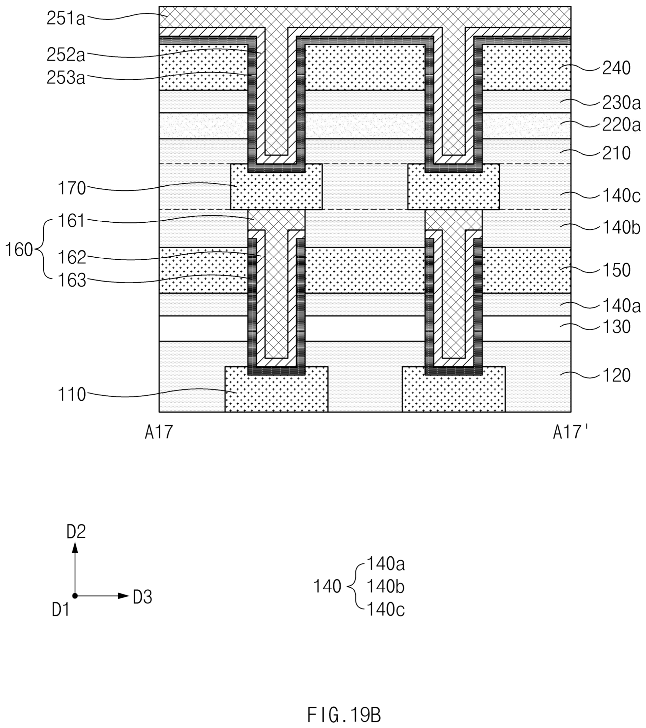

FIG. 19B is a cross-sectional view illustrating an example of the memory cell array taken along the 33^{rd} cutting line (A17-A17') of FIG. 19A.

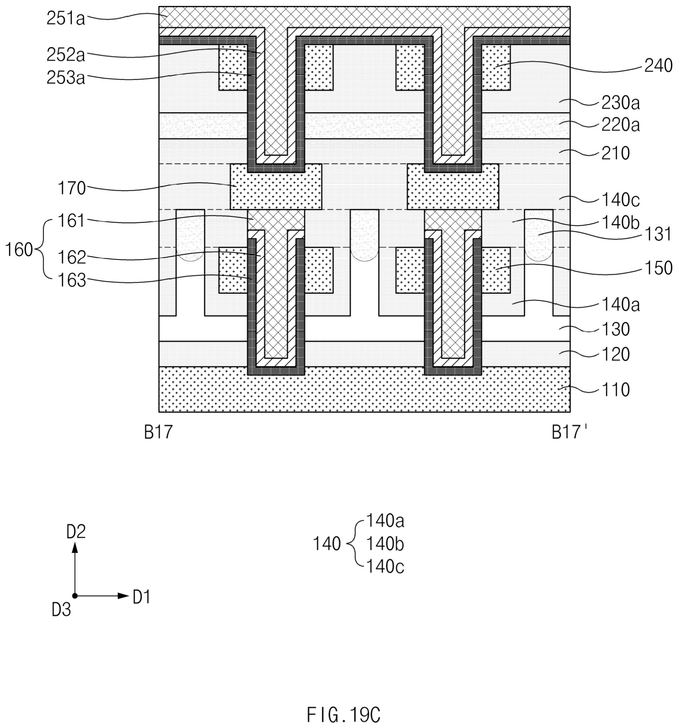

FIG. 19C is a cross-sectional view illustrating an example of the memory cell array taken along the 34^{th} cutting line (B17-B17') of FIG. 19A.

Referring to FIGS. 19A to 19C, a second pre-channel region (253a), a second pre-gate insulation layer (252a), and a second pre-gate (251a) may be sequentially formed within a second channel hole (250a).

The second pre-channel region (253a) may include an oxide semiconductor material. For example, the oxide semiconductor material may include indium gallium zinc oxide (IGZO).

The second pre-channel region (253a) may be formed to surround the bottom and side surfaces of the second channel hole (250a). The bottom surface of the second pre-channel region (253a) may contact the storage node 170, and a portion of the side surface of the second pre-channel region (253a) may contact the second bitline 240.

A second pre-gate insulation layer (252a) may be formed over the second pre-channel region (253a). The second pre-gate insulation layer (252a) may include an insulation material such as silicon oxide.

The second pre-gate (251a) may be formed over the second pre-gate insulation layer (252a). The second pre-gate (251a) may include metal, metal nitride, polysilicon, a combination thereof, or multilayers thereof.

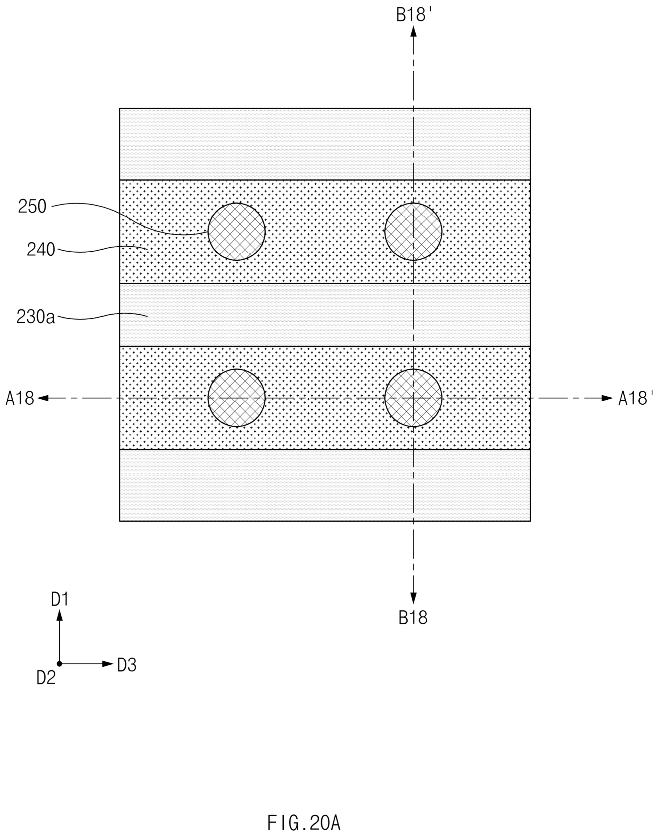

FIGS. 20A to 20C are diagrams illustrating examples of a method for forming the second channel structure 250.

FIG. 20A is a plan view illustrating an example of a method for manufacturing the memory cell array when viewed from the second direction (D2) according to an embodiment of the present disclosure.

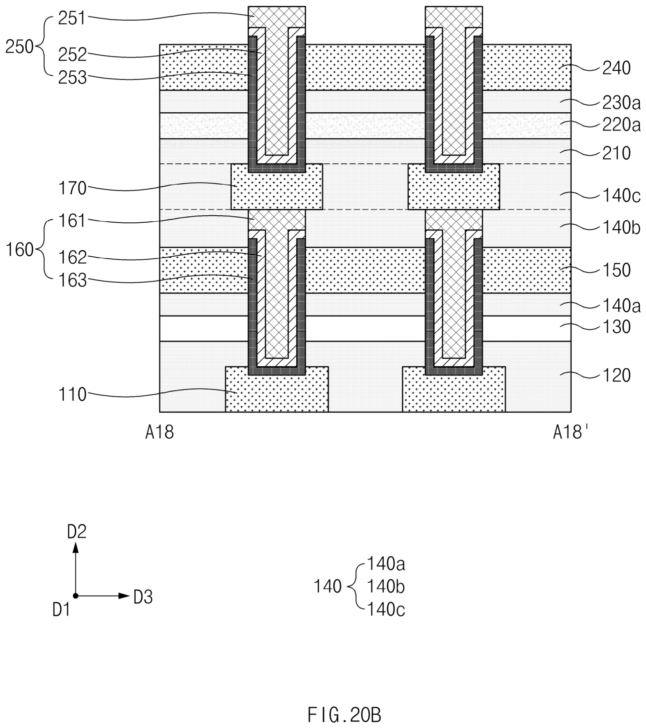

FIG. 20B is a cross-sectional view illustrating an example of the memory cell array taken along the 35^{th} cutting line (A18-A18') shown in FIG. 20A.

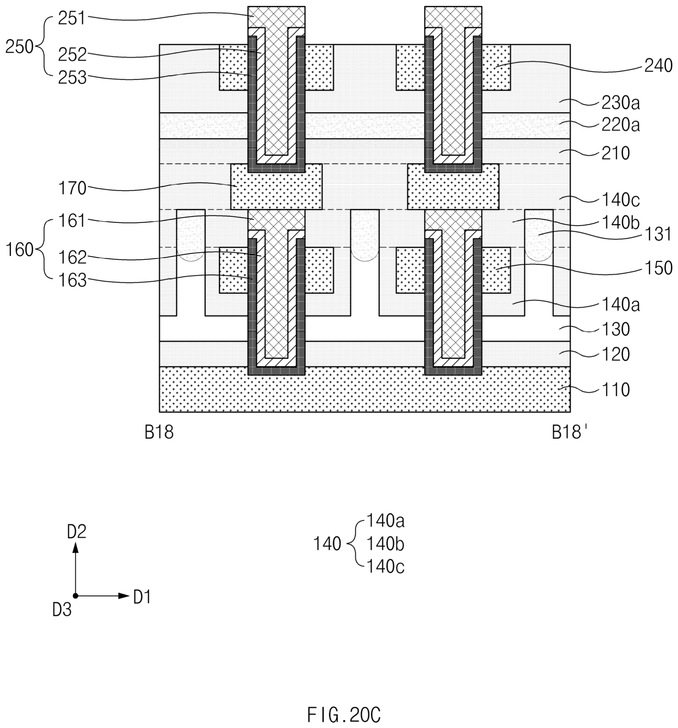

FIG. 20C is a cross-sectional view illustrating an example of the memory cell array taken along the 36^{th} cutting line (B18-B18') shown in FIG. 20A.

Referring to FIGS. 20A to 20C, a second channel structure 250 may be formed by selectively removing a portion of the second pre-channel region (253a), the second pre-gate insulation layer (252a), and the second pre-gate (251a).

A plurality of second gates 251 may be electrically isolated from each other by selectively removing a portion of the second pre-channel region (253a), the second pre-gate insulation layer (252a), and the second pre-gate (251a). In addition, a plurality of second channel regions 253 arranged adjacent to each other in the first direction (D1) may be electrically isolated from each other.

On the other hand, a plurality of second channel regions 253 arranged adjacent to each other in the third direction (D3) may be electrically connected to each other by the second bitlines 240.

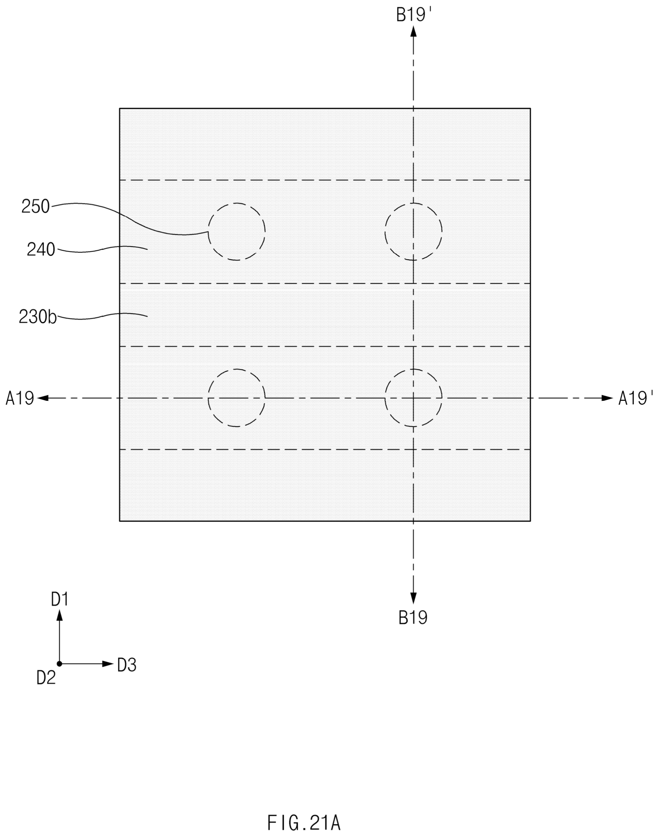

FIGS. 21A to 21C are diagrams illustrating examples of a method for forming the fourth insulation layer 230.

FIG. 21A is a plan view illustrating an example of a method for manufacturing the memory cell array when viewed from the second direction (D2) according to an embodiment of the present disclosure.

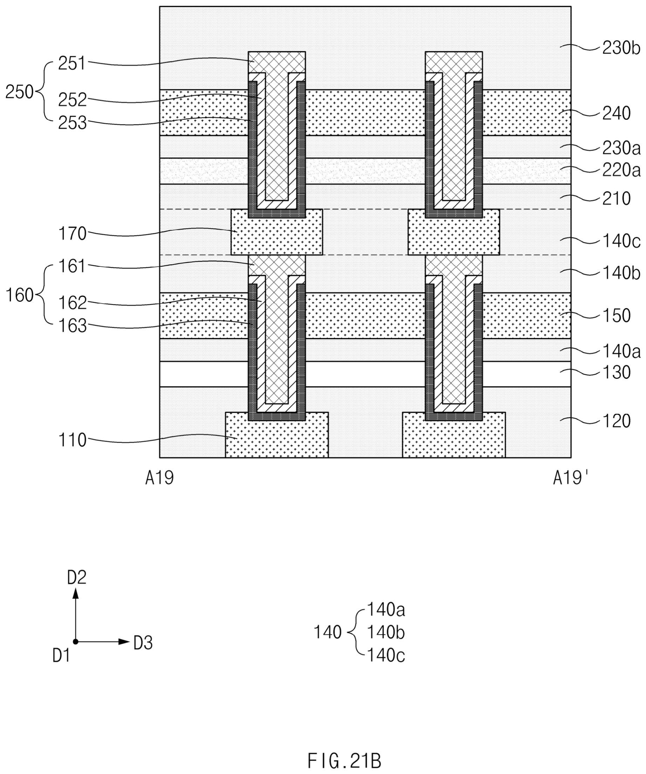

FIG. 21B is a cross-sectional view illustrating an example of the memory cell array taken along the 37^{th} cutting line (A19-A19') shown in FIG. 21A.

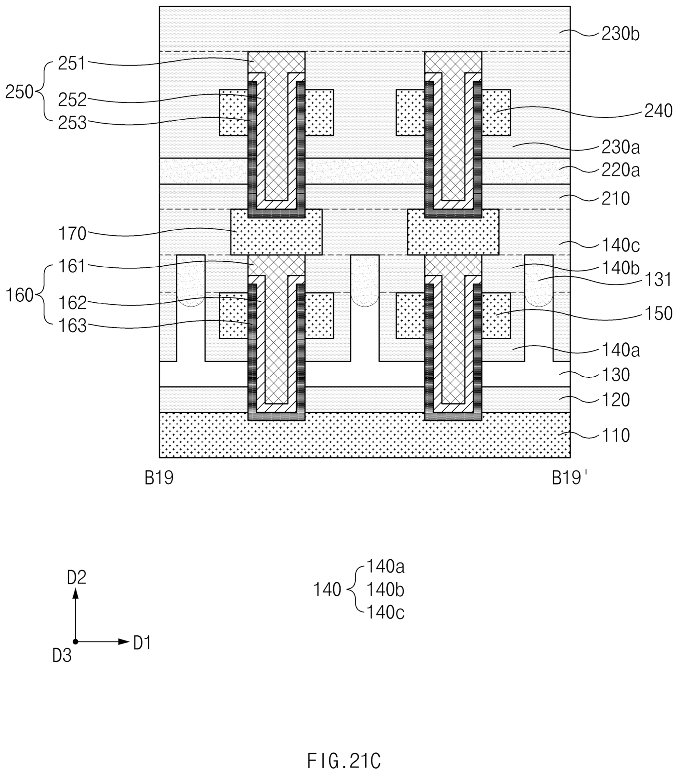

FIG. 21C is a cross-sectional view illustrating an example of the memory cell array taken along the 38^{th} cutting line (B19-B19') shown in FIG. 21A.

Referring to FIGS. 21A to 21C, an insulation layer may be additionally deposited on the second channel structure 250 to form a fourth insulation layer middle end (230b). The fourth insulation layer middle end (230b) may include an insulation material such as silicon nitride. The fourth insulation layer middle end (230b) may be a region included in the fourth insulation layer 230 to be formed later.

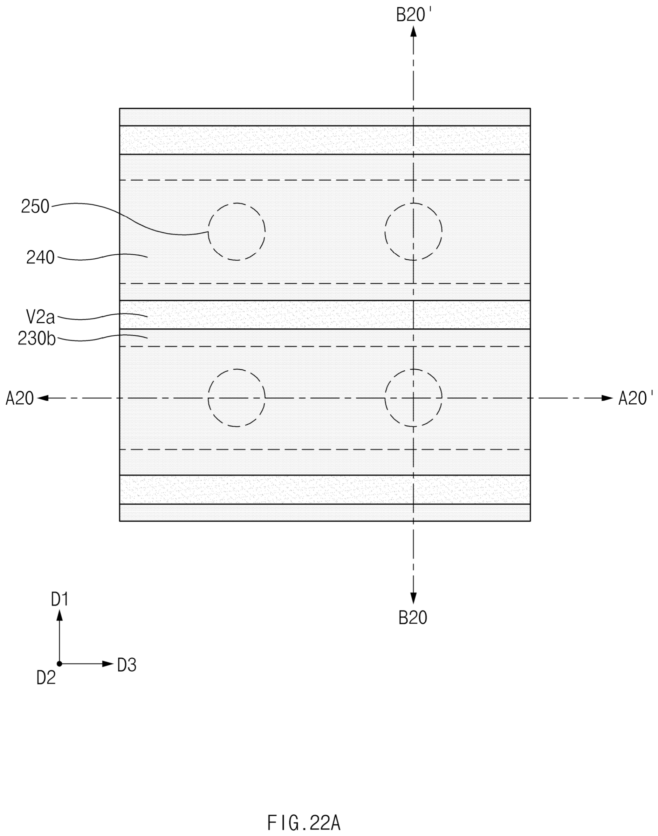

FIGS. 22A to 22C are diagrams illustrating examples of a method for forming one or more second vertical holes (V2a).

FIG. 22A is a plan view illustrating an example of a method for manufacturing the memory cell array when viewed from the second direction (D2) according to one embodiment of the present disclosure.

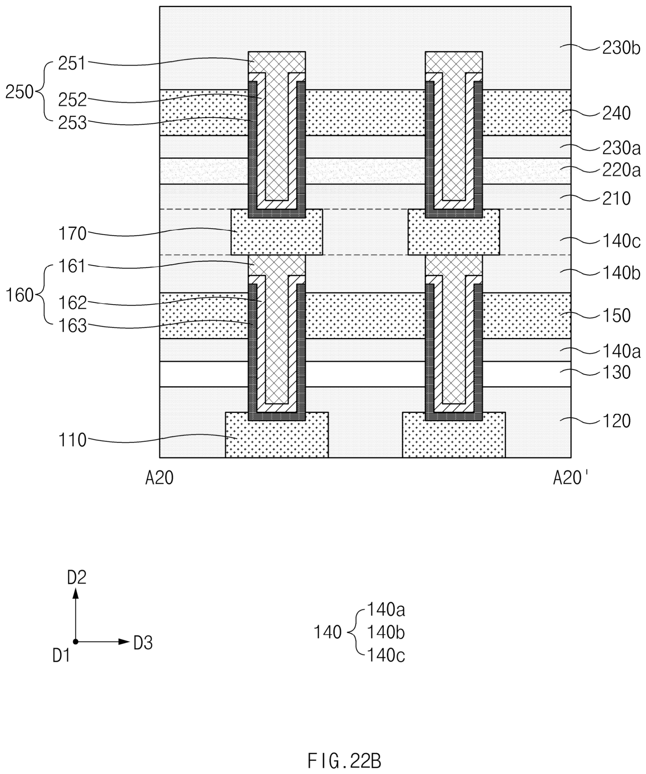

FIG. 22B is a cross-sectional view illustrating an example of the memory cell array taken along the 39^{th} cutting line (A20-A20') of FIG. 22A.

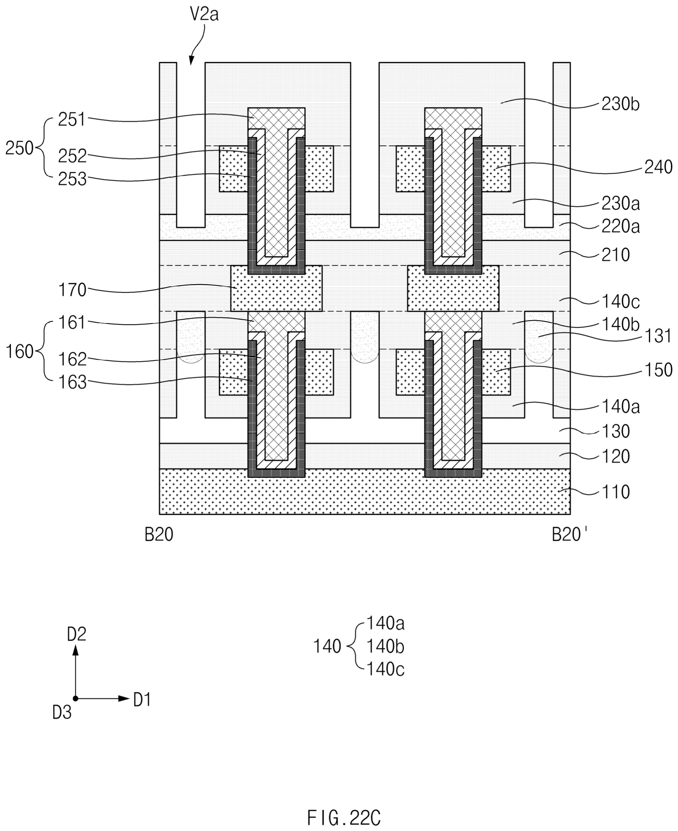

FIG. 22C is a cross-sectional view illustrating an example of the memory cell array taken along the 40^{th} cutting line (B20-B20') of FIG. 22A.

Referring to FIGS. 22A to 22C, each of the second vertical holes (V2a) may be a region obtained by etching the fourth insulation layer middle end (230b) and the fourth insulation layer lower end (230a), and may be a region connected to the second sacrificial layer (220a). The second vertical holes (V2a) may be formed by selectively etching the region between adjacent second bitlines 240. The second vertical holes (V2a) may extend in the third direction (D3).

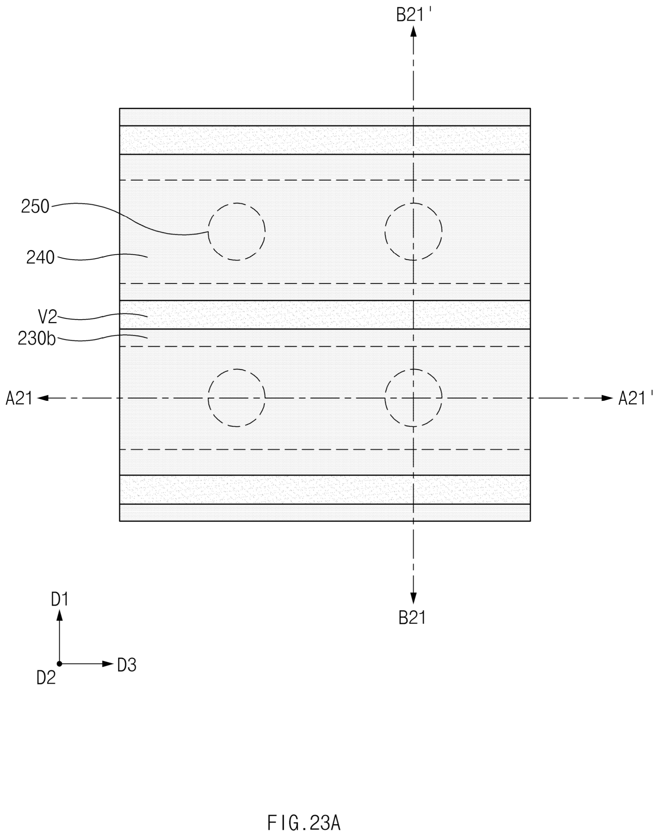

FIGS. 23A to 23C are diagrams illustrating examples of a method for forming the second air layer 220.

FIG. 23A is a plan view illustrating an example of a method for manufacturing the memory cell array when viewed from the second direction (D2) according to one embodiment of the present disclosure.

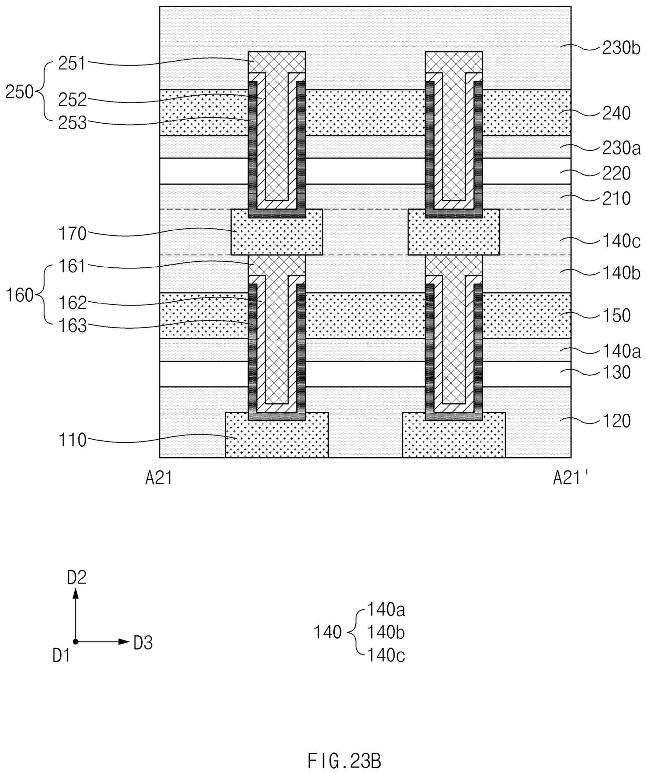

FIG. 23B is a cross-sectional view illustrating an example of the memory cell array taken along the 4l^{st} cutting line (A21-A21') of FIG. 23A.

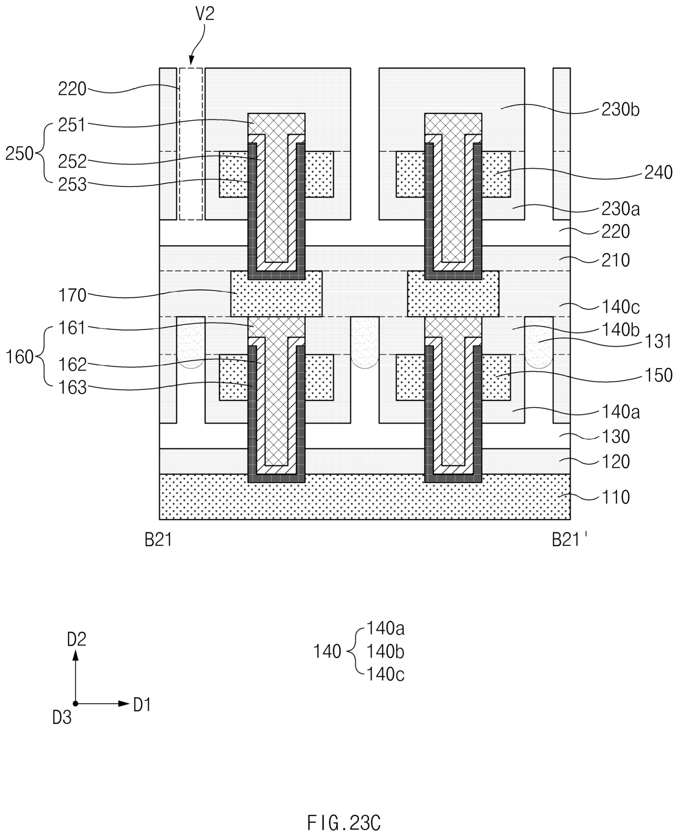

FIG. 23C is a cross-sectional view illustrating an example of the memory cell array taken along the 42^{nd} cutting line (B21-B21') of FIG. 23A.

Referring to FIGS. 23A to 23C, a process of removing the second sacrificial layer (220a) and forming the second air layer 220 through the plasma process is illustrated.

The plasma process may be carried out using gas (e.g., O₂, N₂, H₂, CO, CO₂, or CH₄) including at least one of oxygen, nitrogen, or hydrogen.

The sacrificial layer and the plasma may react with each other, and gas generated through such reaction may be discharged to the outside through the second vertical extension portion (V2). The second air layer 220 may be formed in the region where the second sacrificial layer (220a) is removed.

In some embodiments, the shape of the residual sacrificial layer contacting the sidewall of the second channel region 253 may be adjusted by controlling an execution time and temperature of the plasma process or gas to be used for the plasma process.

For example, when the second sacrificial layer (220a) is completely removed by the plasma process, no residual sacrificial layer may remain in the second air layer 220, as in the embodiments of FIGS. 3A, 3B, and 3C.

On the other hand, when the plasma process is performed so that a portion of the second sacrificial layer (220a) remains, the second residual sacrificial layer 222 may remain in the second air layer 220, as in the embodiments of FIGS. 4A, 4B, and 4C.

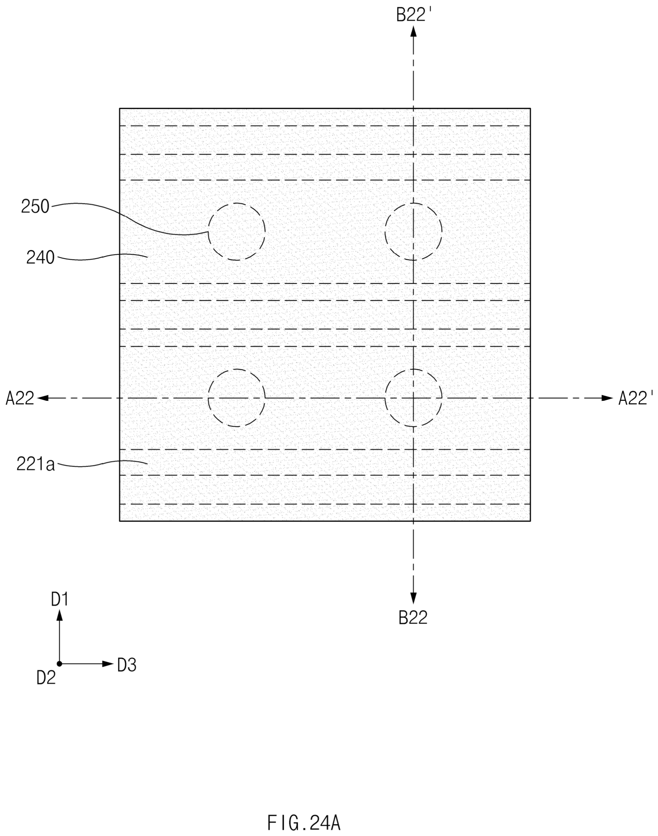

FIGS. 24A to 24C are diagrams illustrating examples of a method for forming the second pre-gapfill region (221a).

FIG. 24A is a plan view illustrating an example of a method for manufacturing the memory cell array when viewed from the second direction (D2) according to an embodiment of the present disclosure.

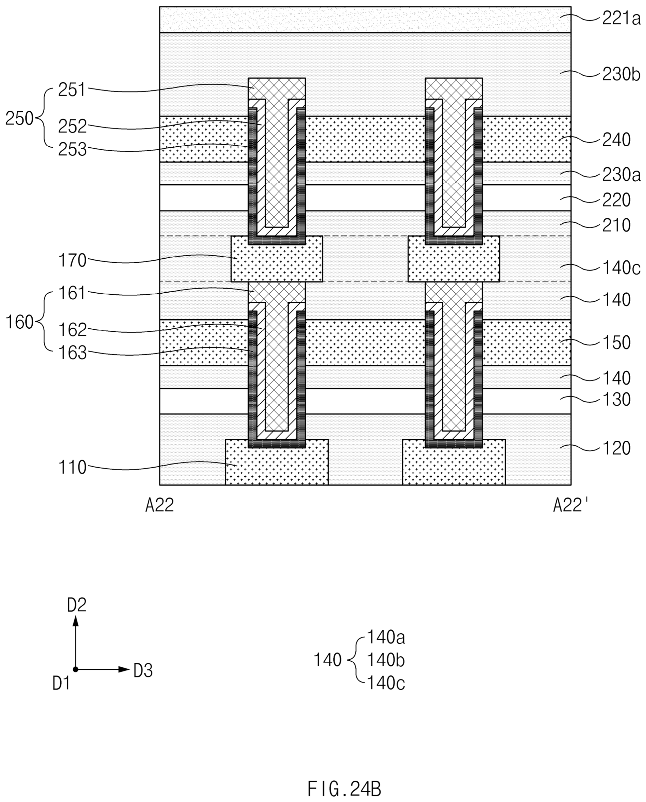

FIG. 24B is a cross-sectional view illustrating an example of the memory cell array taken along the 43^{rd} cutting line (A22-A22') of FIG. 24A.

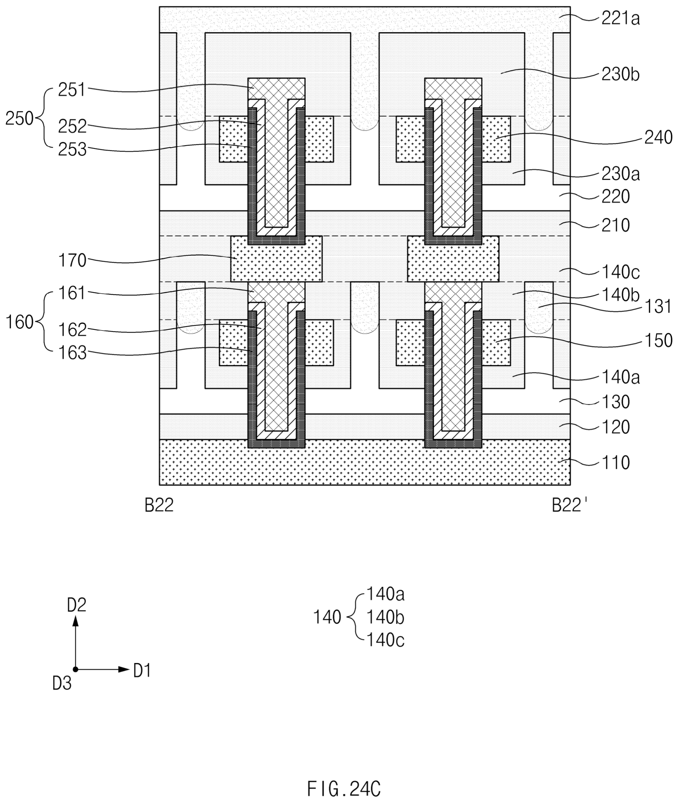

FIG. 24C is a cross-sectional view illustrating an example of the memory cell array taken along the 44^{th} cutting line (B22-B22') of FIG. 24A.

Referring to FIGS. 24A to 24C, a second pre-gapfill region (221a) may be formed on the fourth insulation layer middle end (230b) through a SOD (Spin on Dielectric) process.

The second pre-gapfill region (221a) may include an insulation material such as silicon oxide.

In some embodiments, the second pre-gapfill region (221a) may extend from the upper portion of the fourth insulation layer middle end (230b) into the second vertical extension portion (V2) to a depth at which the second bitline 240 is located.

When the second pre-gapfill region (221a) extends to a depth at which the second bitline 240 is located, the second pre-gapfill region (221a) may function as an insulation layer between adjacent second bitlines 240. The second pre-gapfill region (221a) extending between the adjacent second bitlines 240 may reduce parasitic capacitance occurring between the second bitlines 240.

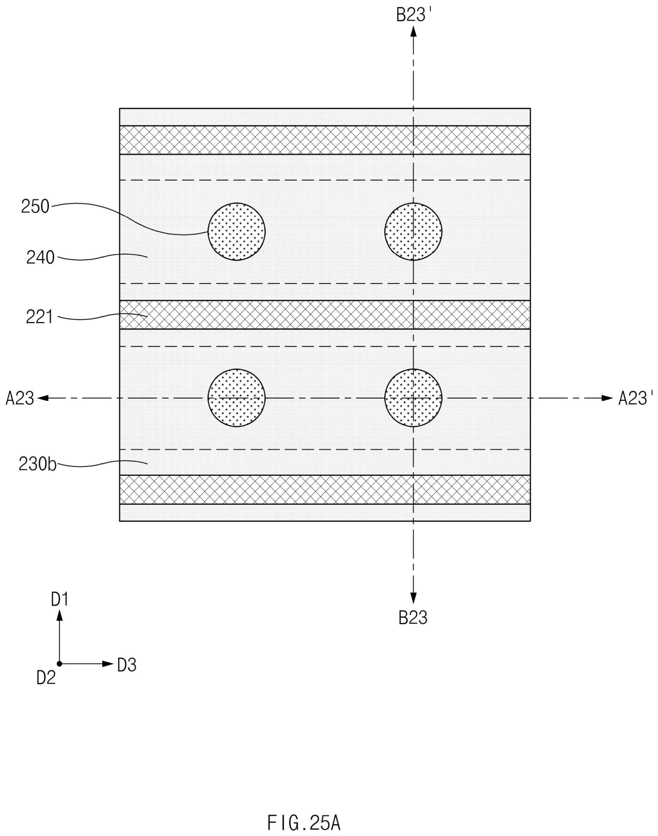

FIGS. 25A to 25C are diagrams illustrating examples of a method for forming the second gapfill region 221.

FIG. 25A is a plan view illustrating an example of a method for manufacturing the memory cell array when viewed from the second direction (D2) according to one embodiment of the present disclosure.

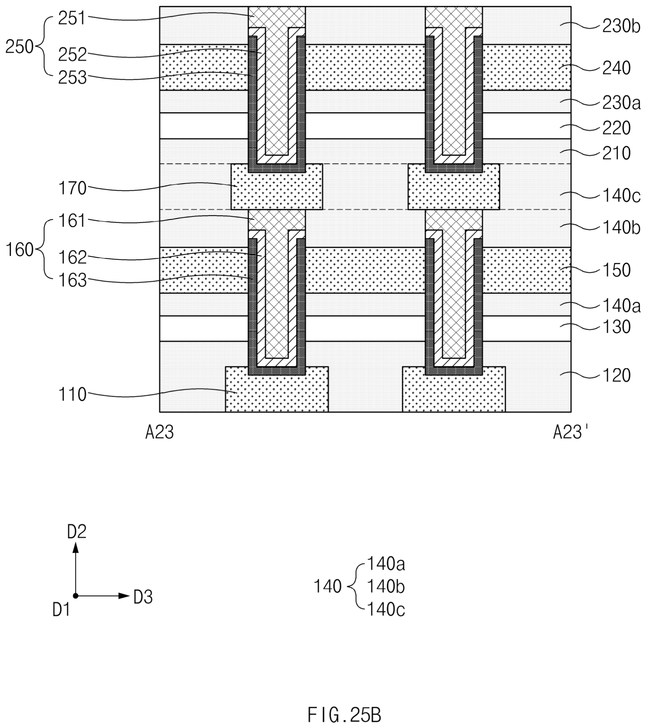

FIG. 25B is a cross-sectional view illustrating an example of the memory cell array taken along the 45^{th} cutting line (A23-A23') of FIG. 25A.

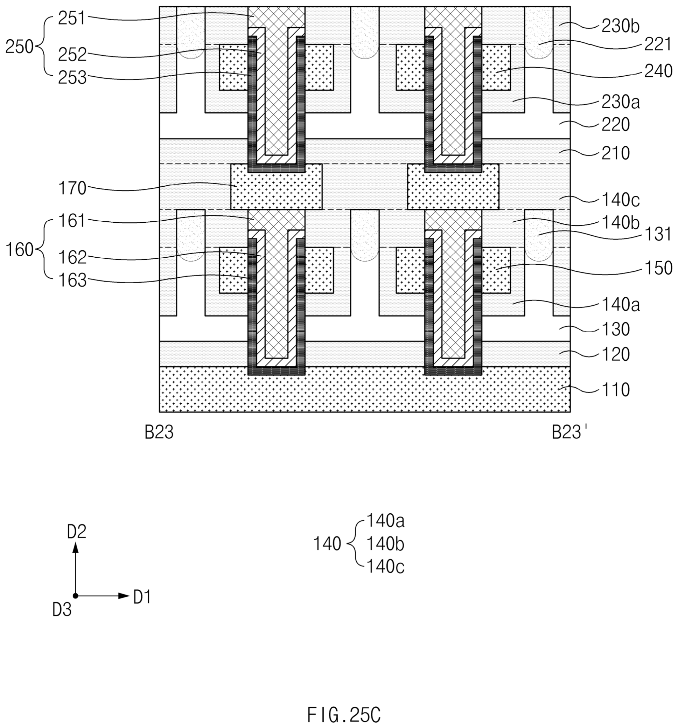

FIG. 25C is a cross-sectional view illustrating an example of the memory cell array taken along the 46^{th} cutting line (B23-B23') of FIG. 25A.

Referring to FIGS. 25A to 25C, a second gapfill region 221 may be formed by removing a portion of the second pre-gapfill region (221a) and a portion of the fourth insulation layer middle end (230b).

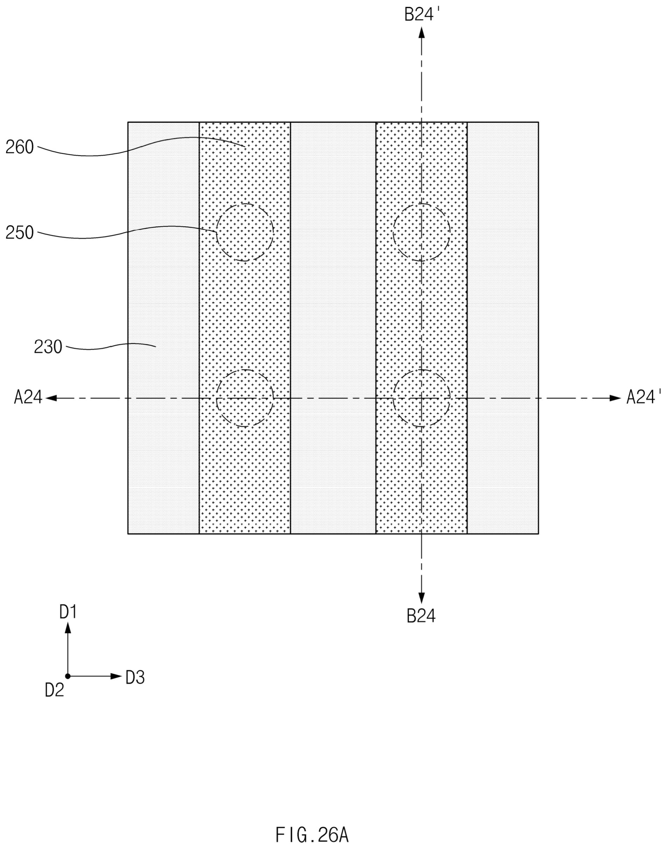

FIGS. 26A to 26C are diagrams illustrating examples of a method for forming one or more second wordlines 260.

FIG. 26A is a plan view illustrating an example of a method for manufacturing the memory cell array when viewed from the second direction (D2) according to an embodiment of the present disclosure.

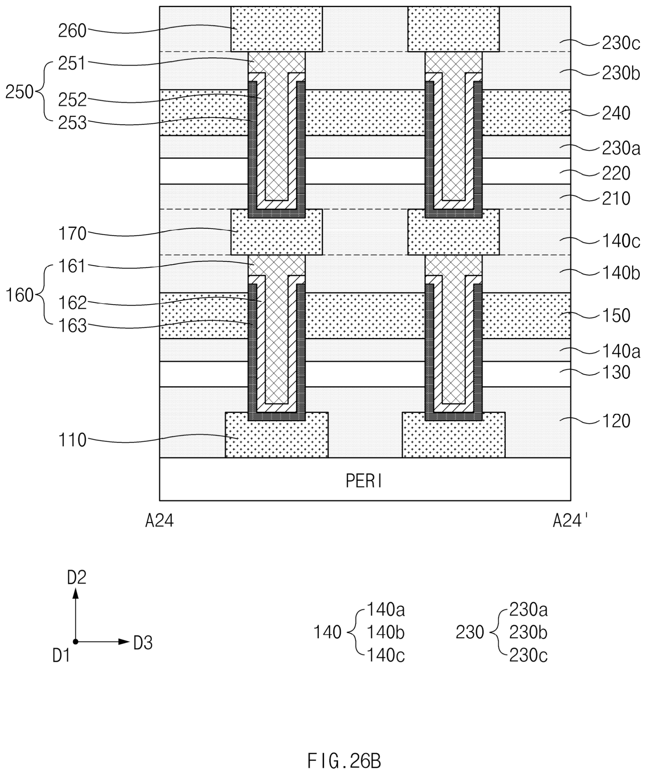

FIG. 26B is a cross-sectional view illustrating an example of the memory cell array taken along the 47^{th} cutting line (A24-A24') of FIG. 26A.

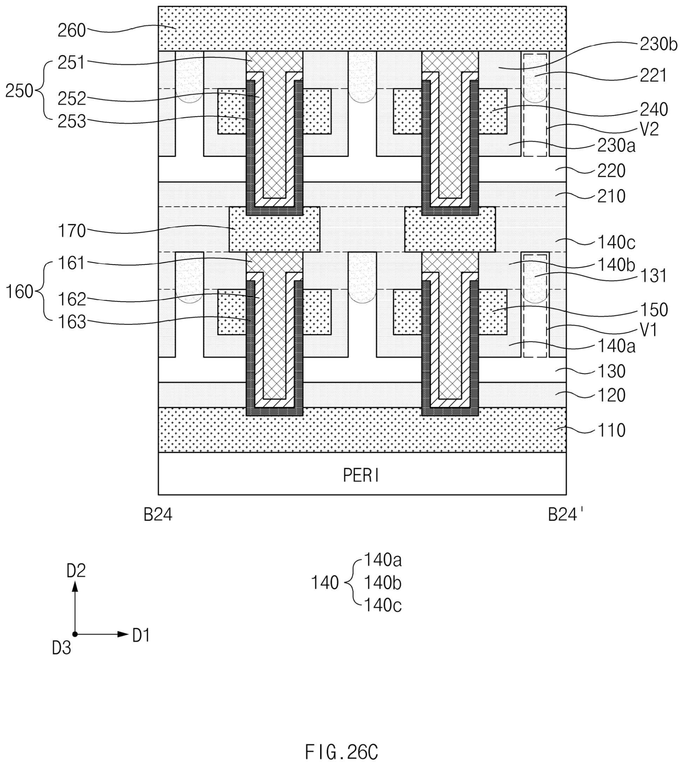

FIG. 26C is a cross-sectional view illustrating an example of the memory cell array taken along the 48^{th} cutting line (B24-B24') of FIG. 26A.

Referring to FIGS. 26A to 26C, the second wordline 260 may be formed over the second gate 251 included in the second channel structure 250.

The second wordline 260 may include metal, metal nitride, polysilicon, a combination thereof, or multilayers thereof.

In some embodiments, the fourth insulation layer upper end (230c) may be additionally formed over the second channel structure 250, and the second wordline 260 may be formed within the fourth insulation layer upper end (230c).

Some regions of the fourth insulation layer upper end (230c) are selectively etched so that a region where the second wordline 260 will be formed can be defined.

The fourth insulation layer 230 may be a region including the fourth insulation layer lower end (230a), the fourth insulation layer middle end (230b), and the fourth insulation layer upper end (230c).

The second wordline 260 may be formed to extend in the first direction (D1).

The second wordline 260 may be commonly connected (e.g., connected in common, form a common contact) to the plurality of second channel structures 250 adjacent to each other in the second direction.

In addition, according to an embodiment, a peripheral region (PERI) may be further formed under the first wordline 110 and the first insulation layer 120. At this time, the peripheral region (PERI) may be a region in which a plurality of transistors and a plurality of control circuits are provided.

As is apparent from the above description, the semiconductor device based on some implementations of the present disclosure includes three-dimensional (3D) channels to improve the degree of integration.

The semiconductor device based on some implementations of the present disclosure includes at least one transistor that operates as a storage element, resulting in a simplified fabrication process.

In addition, the semiconductor device based on some embodiments of the present disclosure may include an air layer, resulting in reduction in signal distortion caused by parasitic capacitance.

The embodiments of the present disclosure may provide a variety of effects capable of being directly or indirectly recognized through the above-mentioned patent document.

Those skilled in the art will appreciate that the present disclosure may be carried out in other specific ways than those set forth herein. In addition, claims that are not explicitly presented in the appended claims may be presented in combination as an embodiment or included as a new claim by a subsequent amendment after the application is filed.

Although a number of illustrative embodiments have been described, it should be understood that modifications and enhancements to the disclosed embodiments and other embodiments can be devised based on what is described and/or illustrated in this patent document.

## Claims

1. A semiconductor device comprising:
a first channel structure;
a first air layer configured to surround a side surface of the first channel structure;
first bitlines configured to contact the side surface of the first channel structure;
a first wordline configured to contact a lower portion of the first channel structure;
a storage node having one end configured to contact an upper portion of the first channel structure;
a second channel structure configured to contact an upper portion of the storage node;
a second air layer configured to surround a side surface of the second channel structure;
second bitlines configured to contact the side surface of the second channel structure; and
a second wordline configured to contact an upper portion of the second channel structure,
wherein:
the first bitlines extend in a first vertical direction perpendicular to a direction in which the first channel structure extends; and
the second wordlines extend in a second vertical direction perpendicular to a direction in which the second channel structure extends.

2. The semiconductor device according to claim 1, wherein the direction in which the first bitlines extend is perpendicular to the direction in which the second wordline extends.

3. The semiconductor device according to claim 1, wherein the first air layer includes a first vertical extension portion disposed between two adjacent first bitlines.

4. The semiconductor device according to claim 1, wherein the second air layer includes a second vertical extension portion disposed between two adjacent second bitlines.

5. The semiconductor device according to claim 1,
wherein the first channel structure includes:
a first gate having a pillar shape extending in the first vertical direction;
a first gate insulation layer configured to surround a side surface and a bottom surface of the first gate; and
a first channel region configured to surround the first gate insulation layer, and
wherein the second channel structure includes:
a second gate having a pillar shape extending in the second vertical direction;
a second gate insulation layer configured to surround a side surface and a bottom surface of the second gate; and
a second channel region configured to surround the second gate insulation layer.

6. The semiconductor device according to claim 1, further comprising a peripheral region disposed below the first wordline.

7. The semiconductor device according to claim 3, wherein the first air layer includes a first gapfill region disposed in the first vertical extension portion.

8. The semiconductor device according to claim 4, wherein the second air layer includes a second gapfill region disposed in the second vertical extension portion.

9. The semiconductor device according to claim 1, wherein the first air layer includes a first residual sacrificial layer disposed to contact a sidewall of the first channel structure.

10. The semiconductor device according to claim 1, wherein the second air layer includes a second residual sacrificial layer disposed to contact a sidewall of the second channel structure.

11. The semiconductor device according to claim 1, wherein the first air layer is disposed between the first bitline and the first wordline and configured to surround a portion of a sidewall of the first channel structure.

12. The semiconductor device according to claim 1, wherein the second air layer is disposed between the second bitline and the second wordline and configured to surround a portion of a sidewall of the second channel structure.

13. A semiconductor device comprising:
a plurality of first wordlines each configured to extend in a first direction;
a plurality of first channel structures respectively configured to contact upper portions of the plurality of first wordlines and to extend in a second direction perpendicular to the first direction;
a plurality of first bitlines having a common contact to side surfaces of first channel structures arranged parallel to each other in a third direction, among the plurality of first channel structures;
a first air layer disposed between the plurality of first channel structures;
a plurality of storage nodes respectively configured to contact upper portions of the plurality of first channel structures;
a plurality of second channel structures respectively configured to contact the plurality of storage nodes and to extend in the second direction;
a plurality of second bitlines having a common contact to side surfaces of second channel structures arranged parallel to each other in the third direction, among the plurality of second channel structures;
a second air layer disposed between the plurality of second channel structures; and
a plurality of second wordlines respectively configured to contact upper portions of second channel structures arranged parallel to each other in the first direction, among the plurality of second channel structures.

14. The semiconductor device according to claim 13,
wherein each of the plurality of first channel structures includes:
a first gate having a pillar shape extending in a vertical direction;
a first gate insulation layer configured to surround a side surface and a bottom surface of the first gate; and
a first channel region configured to surround the first gate insulation layer, and
wherein each of the plurality of second channel structures includes:
a second gate having a pillar shape extending in the vertical direction;
a second gate insulation layer configured to surround a side surface and a bottom surface of the second gate; and
a second channel region configured to surround the second gate insulation layer.

15. A method for manufacturing a semiconductor device, the method comprising:
forming a first wordline on a substrate;
forming a first bitline over the first wordline;
forming a first channel structure so that a bottom surface of the first channel structure contacts the first wordline and a side surface of the first channel structure contacts the first bitline;
forming a first air layer to surround a side surface of the first channel structure;
forming a storage node to contact a top surface of the first channel structure;
forming a second bitline over the storage node;
forming a second channel structure so that a bottom surface of the second channel structure contacts the storage node and a side surface of the second channel structure contacts the second bitline; and
forming a second air layer to surround a side surface of the second channel structure.
